# EUROPEAN PATENT APPLICATION

(11) **EP 4 539 646 A1**
(43) Date of publication of application: **16.04.2025**
(21) Application number: 24205381.7
(22) Date of filing: 08.10.2024
(51) Int. Cl.: H10K 59/131

(54) **DISPLAY DEVICE AND MANUFACTURING METHOD OF THE SAME**

(30) Priority: 11.10.2023 KR 20230134748
(71) Applicant: Samsung Display Co., Ltd., Gyeonggi-Do (KR)
(72) Inventor: SONG, Si Joon, Yongin-si (KR); PARK, Sangho, Yongin-si (KR); LEE, Jaehak, Yongin-si (KR); LEE, Donghyun, Yongin-si (KR)
(74) Representative: Marks & Clerk LLP

(57) **Abstract**

A display device including a display panel including a display region and a non-display region, wherein the display panel includes a base layer overlapping the display region and the non-display region, a pad electrode exposed through a lower surface of the base layer, a pixel disposed on an upper surface of the base layer and including a light-emitting element overlapping the display region, a data line disposed on the upper surface of the base layer and overlapping the display region and the non-display region, and electrically connected to the pad electrode, an electrostatic protection circuit electrically connected to the data line, wherein the electrostatic protection circuit includes a first diode disposed in the non-display region and a second diode overlapping at least a portion of the first diode in a plan view.

## Description

### BACKGROUND

### 1. Technical Field

The disclosure relates to a display device capable of backside bonding with a flexible circuit board and a manufacturing method thereof.

### 2. Description of the Related Art

Electronic devices such as smart phones, tablets, laptop computers, car navigation systems, and smart televisions are being developed. These electronic devices may be equipped with a display device to provide information.

Various types of display devices are being developed to satisfy users' UX/UI (or user experience / user interface). Display devices are being developed to provide not only a wide display region, but also a narrow non-display region.

### SUMMARY

The disclosure provides a display device with a reduced non-display region and a method of manufacturing the same.

An embodiment of the disclosure (or inventive concept) provides a display device that includes a display panel including a display region and a non-display region, wherein the display panel includes a base layer overlapping the display region and the non-display region and comprises an upper surface opposite a lower surface; a pad electrode exposed through the lower surface of the base layer; a pixel disposed on the upper surface of the base layer and including a light-emitting element overlapping the display region and a transistor electrically connected to the light-emitting element; a data line disposed on the upper surface of the base layer, overlapping the display region and the non-display region, and electrically connected to the transistor; an electrostatic protection circuit electrically connected to the data line; and a connection electrode electrically connecting the data line and the pad electrode to each other in the non-display region, wherein the electrostatic protection circuit includes a first diode disposed in the non-display region and a second diode disposed on the first diode and overlapping at least a portion of the first diode in a plan view.

In an embodiment, the first diode may include a silicon semiconductor, and the second diode may include an oxide semiconductor.

In an embodiment, the second diode may entirely overlap the first diode.

In an embodiment, the data line may extend in a first direction, and the length of the electrostatic protection circuit in the first direction may be in a range of about 200 micrometers to about 300 micrometers.

In an embodiment, the display panel may further include a plurality of insulating layers disposed on the upper surface of the base layer. The connection electrode may be electrically connected to the pad electrode through a first contact hole, the first contact hole may pass through at least one of the plurality of insulating layers and may be defined in the base layer, the connection electrode may be electrically connected to the data line through a second contact hole passing through at least one of the plurality of insulating layers.

In an embodiment, the base layer may include a first synthetic resin layer providing the lower surface of the base layer and having a first opening, the first opening may expose the pad electrode; a first inorganic base layer disposed on the first synthetic resin layer and having a second opening, the second opening may expose the pad electrode, the second opening may correspond to the first opening; a second inorganic base layer disposed on the first inorganic base layer and covering the pad electrode; and a second synthetic resin layer disposed on the second inorganic base layer. The first contact hole may pass through the second synthetic resin layer and the second inorganic base layer.

In an embodiment, the display panel may further include an additional electrostatic protection circuit electrically connected to the data line and disposed closer to the display region than the electrostatic protection circuit.

In an embodiment, the plurality of insulating layers may include a first inorganic insulating layer. At least a portion of the first diode may be disposed below the first inorganic insulating layer, and the second diode may be disposed above the first inorganic insulating layer.

In an embodiment, the first diode may include a first pattern disposed below the first inorganic insulating layer, the first pattern may include a silicon semiconductor, and the second diode may include a second pattern disposed above the first inorganic insulating layer, the second pattern may include an oxide semiconductor.

In an embodiment, the first pattern and the second pattern may overlap each other in a plan view.

In an embodiment, the base layer may include a first base portion overlapping the display region, and a second base portion protruding from the first base portion in a first direction. A width of the second base portion in a second direction intersecting the first direction may be smaller than a width of the first base portion, and the electrostatic protection circuit may be disposed on the second base portion.

In an embodiment, the display panel may further include a lighting pad line disposed on the second base portion, extending to an end of the second base portion, and having a width greater than that of the data line.

In an embodiment, the display panel may further include a molding portion covering an end of the second base portion.

In an embodiment, the data line may extend in a first direction, and the electrostatic protection circuit may include a plurality of electrostatic protection circuit portions spaced apart from each other in a second direction crossing the first direction.

In an embodiment, the transistor may include a silicon transistor including a silicon semiconductor, and an oxide transistor disposed on the silicon transistor and including an oxide semiconductor. The first diode may be disposed on the same layer as the silicon transistor, and the second diode may be disposed on the same layer as the oxide transistor.

In an embodiment of the disclosure, a display device may include a display panel including a display region and a non-display region. The display panel may include a base layer overlapping the display region and the non-display region and may comprise an upper surface opposite a lower surface; a pad electrode exposed through the lower surface of the base layer; a pixel disposed on the upper surface of the base layer and including a light-emitting element overlapping the display region and a transistor electrically connected to the light-emitting element; a data line disposed on the upper surface of the base layer, overlapping the display region and the non-display region, and electrically connected to the transistor; and an electrostatic protection circuit electrically connected to the data line. The electrostatic protection circuit may include a first diode disposed in the non-display region and including a silicon semiconductor and a second diode disposed on the first diode and including an oxide semiconductor.

In an embodiment of the disclosure, a method for manufacturing a display device including a display region and a non-display region, the method includes performing a test by applying a voltage through a re-test pad disposed in the non-display region and removing a portion of the non-display region. In the performing of the test, an electrostatic protection circuit is electrically connected to the re-test pad. The electrostatic protection circuit includes a first diode disposed in the non-display region, and a second diode disposed on the first diode and overlapping at least a portion of the first diode in a plan view.

In an embodiment, in the removing of a portion of the non-display region, a first portion in which the re-test pad is disposed may be removed.

In an embodiment, in the removing of a portion of the non-display region, a first portion in which the re-test pad is disposed and a second portion in which the electrostatic protection circuit is disposed may be removed.

In an embodiment of the disclosure, the method of manufacturing the display device may further include forming a molding portion to cover at least a portion of the non-display region after the removing of the portion of the non-display region.

At least some of the above and other features of the invention are set out in the claims.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain principles of the disclosure. In the drawings:
FIG. 1 is a perspective view of an electronic device according to an embodiment of the disclosure;
FIG. 2 is an exploded perspective view of the electronic device according to an embodiment of the disclosure;
FIG. 3 is a schematic cross-sectional view of a display device according to an embodiment of the disclosure;
FIG. 4 is a simplified schematic cross-sectional view of a display module according to an embodiment of the disclosure;
FIG. 5 is a plan view of a display panel according to an embodiment of the disclosure;
FIG. 6 is a schematic cross-sectional view of the display module according to an embodiment of the disclosure;
FIG. 7A is a plan view of an input sensor according to an embodiment of the disclosure;
FIG. 7B is a schematic cross-sectional view of the input sensor corresponding to II-II' in FIG. 7A;
FIG. 8 is an enlarged plan view of a non-display region of the display module according to an embodiment of the disclosure;
FIG. 9A is an enlarged plan view of a non-display region of the display module according to an embodiment of the disclosure;
FIG. 9B is a schematic cross-sectional view of the display module corresponding to line III-III' of FIG. 9A;
FIG. 9C is a schematic diagram of an additional electrostatic protection circuit illustrated in FIG. 9A;
FIG. 10A is an enlarged plan view of a non-display region of the display module according to an embodiment of the disclosure;
FIG. 10B is a schematic cross-sectional view of the display module corresponding to line IV-IV' of FIG. 10A;
FIG. 10C is a schematic diagram of an electrostatic protection circuit portion illustrated in FIG. 10B;
FIGS. 11A and 11B are plan views of electrostatic protection circuit portions according to an embodiment of the disclosure;
FIG. 12 is a schematic cross-sectional view of the display module corresponding to line V-V' of FIG. 10A;
FIG. 13 is a flowchart showing a method of manufacturing a display device according to an embodiment of the disclosure; and
FIGS. 14A to 14C are plan views illustrating a step of the method of manufacturing the display device according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, embodiments of the disclosure will be described with reference to the drawings.

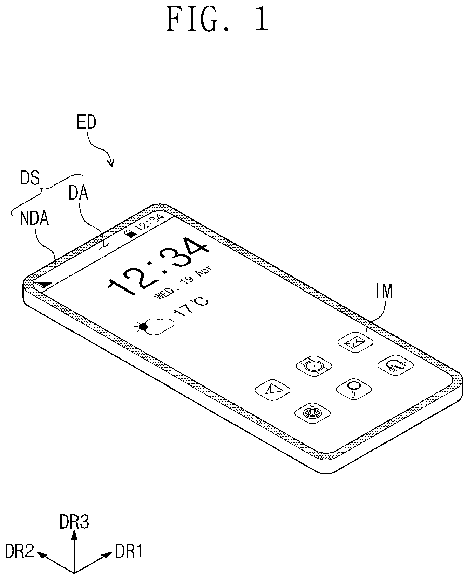

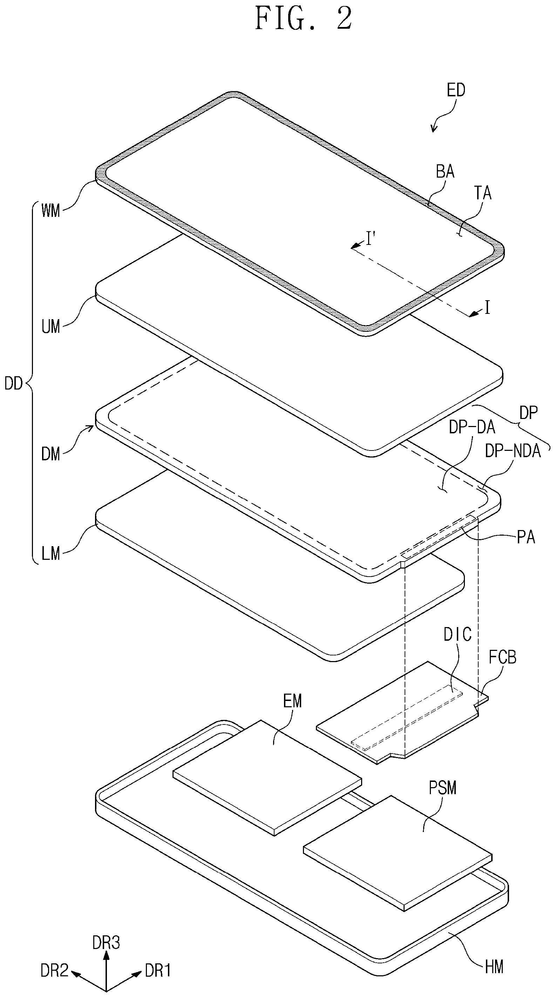

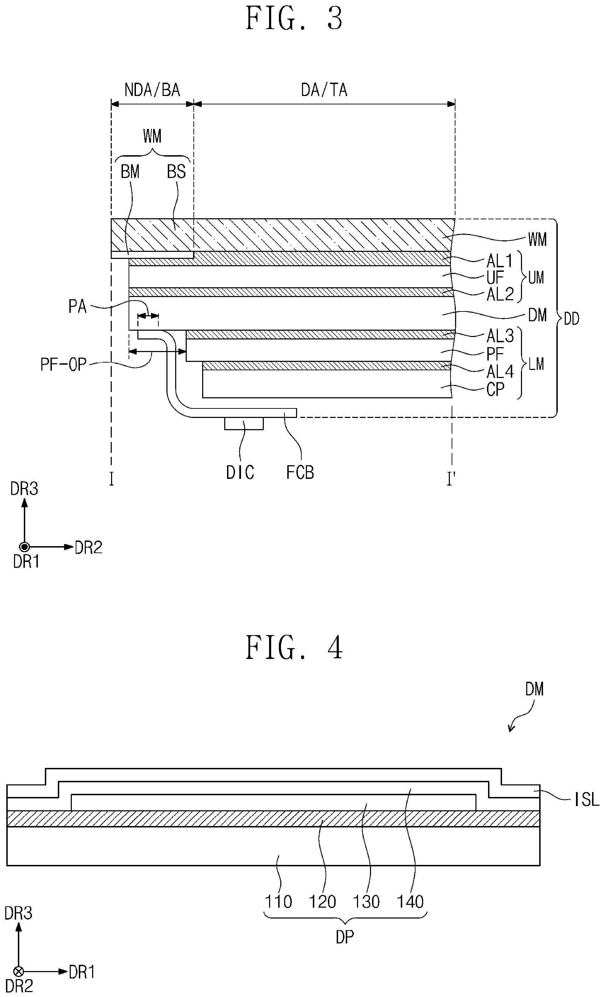

FIG. 1 is a perspective view of an electronic device ED according to an embodiment of the disclosure. FIG. 2 is an exploded perspective view of the electronic device ED according to an embodiment of the disclosure. FIG. 3 is a schematic cross-sectional view of a display device DD according to an embodiment of the disclosure.

Referring to FIG. 1, the electronic device ED according to an embodiment of the disclosure may include a display surface DS defined by a first direction DR1 and a second direction DR2 crossing the first direction DR1. The electronic device ED may provide an image IM to a user through the display surface DS.

The display surface DS may include a display region DA and a non-display region NDA surrounding the display region DA. The display region DA may display an image IM, and the non-display region NDA may not display an image IM. The non-display region NDA may surround the display region DA. Without being limited thereto, however, the shape of the display region DA and the shape of the non-display region NDA may be changed.

Hereinafter, a direction substantially perpendicularly crossing a plane defined by the first direction DR1 and the second direction DR2 may be defined as a third direction DR3. The third direction DR3 serves as a reference for distinguishing the front and rear surfaces of each member. In this specification, the expression "on a plane" may be defined as viewed in the third direction DR3 and may correspond to "in a plan view". Hereinafter, the first to third directions DR1, DR2, and DR3 refer to the same reference numerals as directions indicated by first to third direction axes, respectively.

In an embodiment of the disclosure, the electronic device ED may be a foldable electronic device that can be folded around a folding axis. The folding axis may be parallel to the first direction DR1 or the second direction DR2, and a folding region may be defined in a portion of the display region DA. The electronic device ED may be in-folded so that portions of the display region DA face each other, or out-folded so that portions of the display region DA face away from each other.

As illustrated in FIG. 2, the electronic device ED may include a display device DD, an electronic module EM, a power module PSM, and a housing HM. FIG. 2 briefly illustrates the electronic device ED, which may further include a mechanical structure (e.g., a hinge) for controlling the operation (e.g., folding or rolling) of the display device DD.

The display device DD creates an image and senses an external input. The display device DD includes a window WM, an upper member UM, a display module DM, a lower member LM, a flexible circuit board FCB, and a driving chip DIC. The upper member UM includes members disposed above the display module DM, and the lower member LM includes members disposed below the display module DM.

The window WM provides the front surface of the electronic device ED. The window WM includes a transmission region TA and a bezel region BA. The display region DA and non-display region NDA of the display surface DS illustrated in FIG. 1 may be defined by the transmission region TA and the bezel region BA. The transmission region TA may be a region through which an image passes, and the bezel region BA may be a region that covers a structure/member disposed below the window WM.

The display module DM may include at least a display panel DP. FIG. 2 illustrates only the display panel DP among the stacked structure of the display module DM, but the display module DM may substantially include not only the display panel DP but also additional components disposed above the display panel DP. A detailed description of the stacked structure of the display module DM will be given later.

The display panel DP may not be particularly limited and may include, for example, an organic light-emitting display panel or an inorganic light-emitting display panel. The display panel DP includes a display region DP-DA and a non-display region DP-NDA corresponding to the display region DA and the non-display region NDA illustrated in FIG. 1. In this specification, an expression "a region/portion corresponds to another region/portion" means that the regions/portions overlap each other and the expression may not be limited to having a same area.

A pad region PA of the display panel DP may be disposed on one side of the non-display region DP-NDA. The pad region PA may be a region that is electrically bonded (or electrically connected) to a flexible circuit board FCB which will be described later. In this embodiment, the pad region PA may be defined on the rear surface of the display panel DP.

The display panel DP has a substantially tetragonal shape. Here, "the substantially tetragonal shape" includes not only a tetragonal shape in the mathematical sense, but also a shape similar to a tetragonal shape, which may be perceived by a user as a tetragonal shape. For example, a substantially tetragonal shape may include a tetragonal shape with rounded corners. With regard to the substantially tetragonal shape, the edges of the display panel DP may not be limited to being straight, and the edges may include curved portions.

The upper member UM may include a protective film or optical film. The optical film may include a polarizer and a retarder to reduce the reflection of external light. The lower member LM may include a protective film to protect the display panel DP, a support member to support the display panel DP, a digitizer, and the like. A detailed description of the upper member UM and lower member LM will be given later.

The flexible circuit board FCB illustrated in FIG. 2 may be disposed below the display panel DP. The flexible circuit board FCB may be bonded to the rear surface of the display panel DP and may electrically connect the display panel DP and a main circuit board to each other. The flexible circuit board FCB includes at least one insulating layer and at least one conductive layer. The conductive layer may include multiple signal lines.

The driving chip DIC may be mounted on the flexible circuit board FCB. The driving chip DIC may include a driving circuit for driving pixels of the display panel DP, for example, a data driving circuit. FIG. 2 illustrates a structure in which the driving chip DIC may be mounted on the flexible circuit board FCB, but the disclosure is not limited thereto. For example, the driving chip DIC may be mounted on the display panel DP or the main circuit board.

The electronic module EM may include a control module, a wireless communication module, a video input module, an audio input module, an audio output module, a memory, an external interface module, and the like. The electronic module EM may include a main circuit board, and the modules may be mounted on the main circuit board or electrically connected to the main circuit board through the flexible circuit board. The electronic module EM may be electrically connected to the power module PSM.

Although not separately illustrated, the electronic device ED may further include an electro-optical module. The electro-optical module may be an electronic component that outputs or receives an optical signal. The electro-optical module may include a camera module and/or a proximity sensor. The camera module may capture an external image through a partial region of the display panel DP.

The housing HM illustrated in FIG. 2 may be coupled to the display device DD, especially the window WM, to accommodate the other modules. The housing HM may be illustrated as having an integral shape, but is not limited thereto. The housing HM may include multiple portions (e.g., a side edge portion and a bottom portion) which may be coupled to each other.

FIG. 3 additionally illustrates adhesive layers AL1 to AL4 which may not be illustrated in FIG. 2. The window WM may include a base substrate BS and a bezel pattern BM disposed on the lower surface of the base substrate BS. The base substrate BS may include a synthetic resin film or a glass substrate. The base substrate BS may have a multi-layered structure. The base substrate BS may include a thin-film glass substrate, a protective film disposed on the thin-film glass substrate, and an adhesive layer that bonds the thin-film glass substrate and the protective film to each other.

The bezel pattern BM may be a colored light blocking film and may be formed, for example, by a coating method. The bezel pattern BM may include a base material and a dye or pigment mixed with the base material. The bezel pattern BM overlaps the non-display region NDA illustrated in FIG. 1 and the bezel region BA illustrated in FIG. 2. The bezel pattern BM may be disposed on the lower surface of the base substrate BS. In the case that the base substrate BS has a multi-layered structure, the bezel pattern BM may be disposed between interfaces defined by multiple layers. For example, the bezel pattern BM may be disposed between the thin-film glass substrate and the protective film. Although not separately illustrated, the window WM may further include at least one of a hard coating layer, an anti-fingerprint layer, or an anti-reflection layer on the upper surface of the base substrate BS.

The upper member UM may include an upper film UF. The upper film UF may include a synthetic resin film. The synthetic resin film may include polyimide, polycarbonate, polyamide, triacetylcellulose, polymethylmethacrylate, or polyethylene terephthalate.

The upper film UF may absorb an external impact applied to the front surface of the display device DD. In an embodiment of the disclosure, the display module DM may include a color filter that replaces a polarizing film as an anti-reflection member, thus making it possible to reduce impact strength on the front surface of the display device DD. The upper film UF may compensate for the reduced impact strength by applying the color filter.

The upper film UF overlaps the bezel region BA and the transmission region TA. The upper film UF may only overlap a portion of the bezel region BA. A portion of the bezel pattern BM may be exposed from the upper film UF. In an embodiment of the disclosure, the upper film UF may be omitted. In an embodiment of the disclosure, the upper film UF may be replaced with an optical film including a polarizer and a retarder.

The upper member UM may further include a first adhesive layer AL1 bonding the upper film UF and the window WM to each other and a second adhesive layer AL2 bonding the upper film UF and the display module DM to each other. The first adhesive layer AL1 and the second adhesive layer AL2 may be a pressure sensitive adhesive film (PSA) or an optically clear adhesive member (OCA). Adhesive layers described below may also include the same adhesive as the first adhesive layer AL1.

The display module DM may be disposed below the upper film UF. The display module DM overlaps the bezel region BA and the transmission region TA. The display module DM may completely overlap the upper film UF in the bezel region BA. The side of the display module DM may be aligned with the side of the upper film UF, and the edge of the display module DM may be aligned with the edge of the upper film UF in a plan view.

In the bezel region BA, the pad region PA may overlap the upper film UF. A portion of the display module DM corresponding to the pad region PA may be coupled to the lower surface of the upper film UF by the second adhesive layer AL2. Since the pad region PA overlaps the upper film UF and a portion of the display module DM overlapping the pad region PA may be coupled to the upper film UF, the upper film UF may sufficiently support the pad region PAin the case that the flexible circuit board FCB may be bonded to the pad region PA.

The lower member LM may include a lower film PF, a cover panel CP, a third adhesive layer AL3 and a fourth adhesive layer AL4. In an embodiment of the disclosure, the lower member LM may further include a support plate and a digitizer.

The lower film PF may be disposed below the display module DM and coupled to the lower surface of the display module DM by the third adhesive layer AL3. The lower film PF may protect the lower portion of the display module DM. The lower film PF may include a flexible synthetic resin film. For example, the lower film PF may include, but may not be limited to polyethylene terephthalate or polyimide.

The lower film PF exposes at least the pad region PA. The lower film PF may have a smaller area than the display module DM. For example, the lower film PF may overlap only the display region DA.

The lower film PF may have substantially the same area as the display module DM. An open region PF-OP corresponding to the pad region PA (see FIG. 2) may be defined in the lower film PF. Although the lower film PF protects the entire lower surface of the display module DM, the open region PF-OP may be defined so that the flexible circuit board FCB approaches the pad region PA.

As illustrated in FIG. 3, the fourth adhesive layer AL4 bonds the lower film PF and the cover panel CP to each other. The cover panel CP may increase resistance to compressive force caused by external pressure. Accordingly, the cover panel CP may serve to prevent deformation of the display panel DP. The cover panel CP may include a flexible plastic material such as polyimide or polyethylene terephthalate. The cover panel CP may be a colored film with a low light transmittance. The cover panel CP may absorb light incident from the outside. For example, the cover panel CP may be a black synthetic resin film. In the case that the display device DD may be viewed from above the window WM, components disposed below the cover panel CP may not be visually recognized by a user.

A support plate may be further disposed below the cover panel CP. The support plate may include a high-strength metal material. The support plate may also include a reinforced fiber composite. The support plate may include reinforced fiber disposed in a matrix portion. The reinforced fiber may be carbon fiber or glass fiber. The matrix portion may include a polymer resin. The matrix portion may include a thermoplastic resin. For example, the matrix portion may include a polyamide-based resin or a polypropylene-based resin. For example, the reinforced fiber composite may be carbon fiber reinforced plastic (CFRP) or glass fiber reinforced plastic (GFRP).

FIG. 4 is a simplified schematic cross-sectional view of a display module DM according to an embodiment of the disclosure.

Referring to FIG. 4, the display module DM may include a display panel DP and an input sensor ISL. The display panel DP may include a base layer 110, a driving element layer 120, a light-emitting element layer 130, and an encapsulation layer 140.

The driving element layer 120 may be disposed on the upper surface of the base layer 110. The base layer 110 may be a flexible substrate capable of being bent, folded, rolled, or the like. The base layer 110 may be a glass substrate, a metal substrate, a polymer substrate, the like, or a combination thereof. However, the embodiment of the disclosure is not limited thereto, and the base layer 110 may be an inorganic layer, an organic layer, or a composite material layer. The base layer 110 may have substantially the same shape as the display panel DP.

The base layer 110 may have a multi-layered structure. For example, the base layer 110 may include a first synthetic resin layer, a second synthetic resin layer, and inorganic layers disposed between them. Each of the first and second synthetic resin layers may include a polyimide-based resin, but the embodiment of the disclosure is not particularly limited thereto.

The driving element layer 120 may be disposed on the base layer 110. The driving element layer 120 may include multiple insulating layers, multiple semiconductor patterns, multiple conductive patterns, signal lines, and the like. The driving element layer 120 may include a pixel driving circuit. Hereinafter, unless otherwise specified, in the case that component A and component B are disposed on a same layer, it may be interpreted that they contain a same material or have a same stacked structure as each other since they may be formed through the same process as each other. Conductive patterns or semiconductor patterns disposed on a same layer may be interpreted as described above.

The light-emitting element layer 130 may be disposed on the driving element layer 120. The light-emitting element layer 130 may include a light-emitting element. For example, the light-emitting element may include an organic light-emitting material, an inorganic light-emitting material, an organic-inorganic light-emitting material, a quantum dot, a quantum rod, a micro LED, or a nano LED.

The encapsulation layer 140 may be disposed on the light-emitting element layer 130. The encapsulation layer 140 may protect the light-emitting element layer 130, that is, the light-emitting element, from moisture, oxygen, and foreign material such as dust particles. The encapsulation layer 140 may include at least one inorganic encapsulation layer. The encapsulation layer 140 may include a stacked structure of a first inorganic encapsulation layer/an organic encapsulation layer/a second inorganic encapsulation layer.

The input sensor ISL may be disposed (e.g., directly disposed) on the display panel DP. The input sensor ISL may sense a user's input, for example, by an electromagnetic induction method or a capacitance method. The display panel DP and the input sensor ISL may be formed through a continuous process. Here, the expression "being directly disposed" may mean that no third component may be disposed between the input sensor ISL and the display panel DP. For example, a separate adhesive layer may not be disposed between the input sensor ISL and the display panel DP.

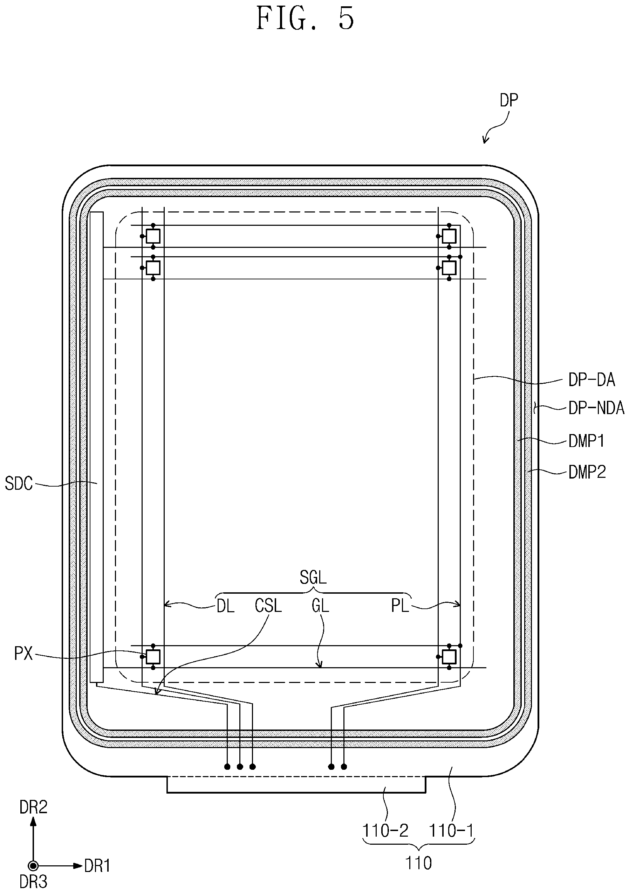

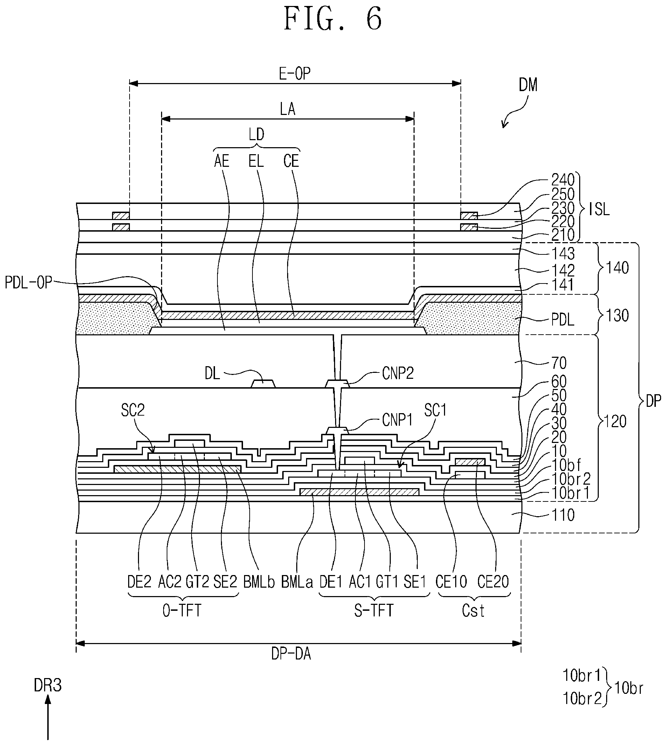

FIG. 5 is a plan view of the display panel DP according to an embodiment of the disclosure. FIG. 6 is a schematic cross-sectional view of the display module DM according to an embodiment of the disclosure.

As illustrated in FIG. 5, the display panel DP may include a scan driving circuit SDC, multiple signal lines SGL, and multiple pixels PX. The pixels PX may be disposed in the display region DP-DA. Each of the pixels PX may include a light-emitting element and a pixel driving circuit electrically connected thereto. The scan driving circuit SDC, the signal lines SGL, and the pixel driving circuit may be included in the driving element layer 120 illustrated in FIG. 4.

The scan driving circuit SDC may include a gate driving circuit. The gate driving circuit may generate multiple scan signals and may sequentially output the scan signals to multiple scan lines GL which will be described later. The scan driving circuit SDC may further include a light-emitting driving circuit that may be distinct from the gate driving circuit. The light-emitting driving circuit may output scan signals to another group of scan lines.

The scan driving circuit SDC may include multiple thin-film transistors formed through the same process as the pixel driving circuit, such as a low temperature polycrystalline silicon (LTPS) process or a low temperature polycrystalline oxide (LTPO) process.

The signal lines SGL include scan lines GL, data lines DL, a power line PL, and a control signal line CSL. Each of the scan lines GL may be electrically connected to a corresponding pixel PX among the pixels PX, and each of the data lines DL may be electrically connected to a corresponding pixel PX among the pixels PX. The power line PL may be electrically connected to multiple pixels PX. The data lines DL provide data signals to the pixels PX. The control signal line CSL may provide control signals to the scan driving circuit SDC.

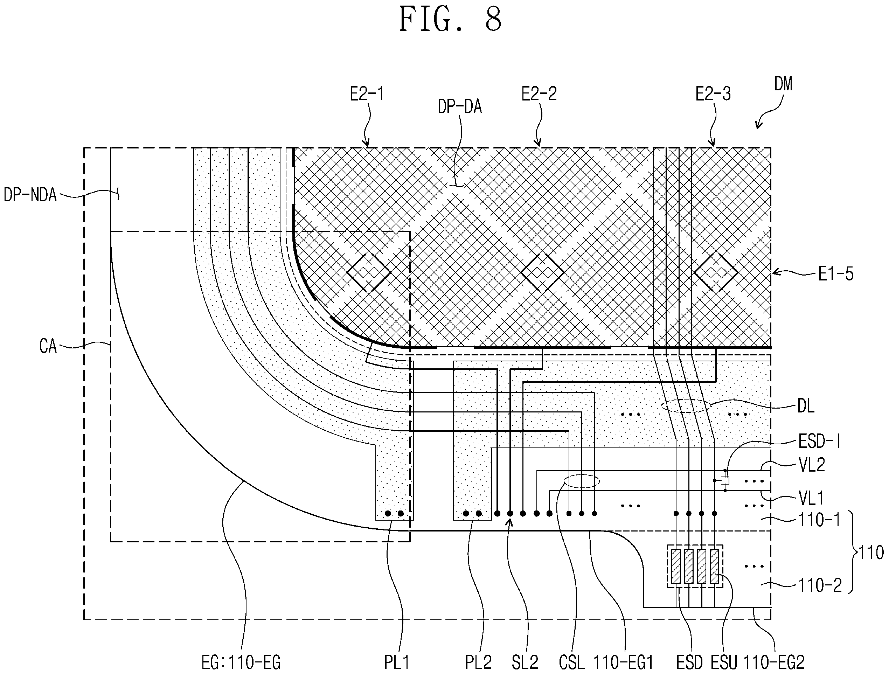

As illustrated in FIG. 8, the power line PL may include a first power line PL1 to receive a first power voltage and a second power line PL2 to receive a second power voltage higher than the first power voltage. The first power voltage may be provided to the pixels PX through the first power line PL1, and the second power voltage may be provided to the pixels PX through the second power line PL2. Although one control signal line CSL is illustrated as an example, the control signal line CSL may be provided in plurality.

The scan lines GL, the data lines DL, and the power line PL may overlap the display region DP-DA and the non-display region DP-NDA, and the control signal line CSL may overlap the non-display region DP-NDA. The ends of the signal lines SGL may be aligned on a side of the non-display region DP-NDA. Each of the signal lines SGL may have an integral shape, but may include multiple portions disposed on different layers. Different portions divided by an insulating layer may be electrically connected through a contact hole passing through the insulating layer. For example, the data lines DL may include a first portion disposed in the display region DP-DA and a second portion disposed in the non-display region DP-NDA and disposed on a layer different from that of the first portion. The first portion and the second portion may include different materials and have different stacked structures.

The display panel DP may include insulating patterns DMP1 and DMP2. FIG. 5 illustrates first and second insulating patterns DMP1 and DMP2. The first and second insulating patterns DMP1 and DMP2 may be disposed in the non-display region DP-NDA and surround the display region DP-DA. Each of the first and second insulating patterns DMP1 and DMP2 may have a closed line shape. The first and second insulating patterns DMP1 and DMP2 serve as a dam to prevent a liquefied organic material from overflowing in an inkjet process of the display panel DP. A detailed explanation of this will be provided later.

The outer shape of the display panel DP in a plan view illustrated in FIG. 5 may substantially correspond to the outer shape of the base layer 110 included in the display panel DP. The base layer 110 may include a first base portion 110-1 including the display region DP-DA, and a second base portion 110-2 protruding from the first base portion 110-1 in the second direction DR2. The width of the second base portion 110-2 in the first direction DR1 may be smaller than the width of the first base portion 110-1 in the first direction DR1. Each component included in the display panel DP may be disposed above the base layer 110.

FIG. 6 illustrates a schematic cross section of the display module DM corresponding to the pixel PX of FIG. 5.

The pixel driving circuit that drives the light-emitting element LD may include multiple pixel driving elements. The pixel driving circuit may include multiple transistors and a capacitor Cst.

Referring to FIG. 6, the base layer 110 may be illustrated as a single layer. The base layer 110 may include a synthetic resin such as polyimide. The base layer 110 may be formed by coating a synthetic resin layer on a work substrate. In the case that the display module DM is completed after a follow-up process is performed, the work substrate may be removed.

Referring to FIG. 6, a barrier layer 10br may be disposed on the base layer 110. The barrier layer 10br prevents foreign material from entering from the outside. The barrier layer 10br may include at least one inorganic layer. The barrier layer 10br may include a silicon oxide layer and a silicon nitride layer. Each of these may be provided in plurality, and the silicon oxide layers and the silicon nitride layers may be alternately stacked on each other.

The barrier layer 10br may include a lower barrier layer 10br1 and an upper barrier layer 10br2. A first shielding electrode BMI,a may be disposed between the lower barrier layer 10br1 and the upper barrier layer 10br2. The first shielding electrode BMI,a may be disposed to correspond to a silicon transistor S-TFT. The first shielding electrode BMI,a may include a metal.

The first shielding electrode BMI,a may receive a bias voltage. The first shielding electrode BMI,a may receive the first power voltage. The first shielding electrode BMI,a may block an electric potential due to polarization from affecting the silicon transistor S-TFT. The first shielding electrode BMI,a may block external light from reaching the silicon transistor S-TFT. In an embodiment of the disclosure, the first shielding electrode BMI,a may be a floating electrode isolated from other electrodes or lines.

A buffer layer 10bf may be disposed on the barrier layer 10br. The buffer layer 10bf may prevent metal atoms or impurities from diffusing from the base layer 110 to a first semiconductor pattern SC1 disposed above the base layer 110. The buffer layer 10bf may include at least one inorganic layer. The buffer layer 10bf may include a silicon oxide layer and a silicon nitride layer.

The first semiconductor pattern SC1 may be disposed on the buffer layer 10bf. The first semiconductor pattern SC1 may include a silicon semiconductor. For example, the silicon semiconductor may include amorphous silicon, polycrystalline silicon, and the like. For example, the first semiconductor pattern SC1 may include low-temperature polysilicon.

The first semiconductor pattern SC1 may have different electrical properties depending on whether or not it may be doped. The first semiconductor pattern SC1 may include a first region with a high conductivity and a second region with a low conductivity. The first region may be doped with an N-type dopant or a P-type dopant. A P-type transistor may include a doped region doped with a P-type dopant, and an N-type transistor may include a doped region doped with an N-type dopant. The second region may be an undoped region or a region doped with a lower concentration than the first region. In this embodiment, the first semiconductor pattern SC1 may be an N-type transistor.

The conductivity of the first region may be greater than that of the second region, and the first region may substantially serve as an electrode or a signal line. The second region may substantially correspond to a channel region (or active region) of a transistor. In other words, a portion of the first semiconductor pattern SC1 may be a channel of a transistor, another portion thereof may be a source or drain of a transistor, and still another portion thereof may be a connection electrode or a connection signal line.

A source region SE1, a channel region AC1 (or active region), and a drain region DE1 of the silicon transistor S-TFT may be formed from the first semiconductor pattern SC1. The source region SE1 and the drain region DE1 may extend in opposite directions from each other from the channel region AC1 on a cross section.

A first insulating layer 10 may be disposed on the buffer layer 10bf. The first insulating layer 10 may cover the first semiconductor pattern SC1. The first insulating layer 10 may be an inorganic layer. The first insulating layer 10 may be a single layer of silicon oxide. Not only the first insulating layer 10 but also the inorganic layer of the driving element layer 120 which will be described later may have a single-layered or multi-layered structure and include at least one of the above-described materials, but the embodiment of the disclosure is not limited thereto.

A gate GT1 of the silicon transistor S-TFT may be disposed on the first insulating layer 10. The gate GT1 may be a portion of a metal pattern. The gate GT1 overlaps the channel region AC1. In the process of doping the first semiconductor pattern SC1, the gate GT1 may be a mask. A first electrode CE10 of the storage capacitor Cst may be disposed on the first insulating layer 10. Unlike what may be illustrated in FIG. 6, the first electrode CE10 may have an integral shape with the gate GT1.

A second insulating layer 20 may be disposed on the first insulating layer 10 and cover the gate GT1. In an embodiment of the disclosure, an upper electrode overlapping the gate GT1 may be further disposed on the second insulating layer 20. A second electrode CE20 overlapping the first electrode CE10 may be disposed on the second insulating layer 20. The upper electrode may have an integral shape with the second electrode CE20 in a plan view.

A second shielding electrode BMI,b may be disposed on the second insulating layer 20. The second shielding electrode BMI,b may be disposed to correspond to the oxide transistor O-TFT. In an embodiment of the disclosure, the second shielding electrode BMI,b may be omitted. According to an embodiment of the disclosure, the first shielding electrode BMLa may extend below the oxide transistor O-TFT and replace the second shielding electrode BMLb.

A third insulating layer 30 may be disposed on the second insulating layer 20. A second semiconductor pattern SC2 may be disposed on the third insulating layer 30. The second semiconductor pattern SC2 may include a channel region AC2 of the oxide transistor O-TFT. The second semiconductor pattern SC2 may include an oxide semiconductor. The second semiconductor pattern SC2 may include a transparent conductive oxide (TCO) such as an indium tin oxide (ITO), an indium zinc oxide (IZO), an indium gallium zinc oxide (IGZO), a zinc oxide (ZnOₓ), an indium oxide (In₂O₃), or a combination thereof.

The oxide semiconductor may include multiple regions SE2, AC2, and DE2 divided depending on whether or not the transparent conductive oxide has been reduced. A region (hereinafter referred to as a reduced region) in which the transparent conductive oxide may be reduced has greater conductivity than a region (hereinafter referred to as a non-reduced region) in which the transparent conductive oxide may not be reduced. The reduced region substantially serves as a source/drain or signal line of a transistor. The non-reduced region substantially corresponds to a semiconductor region (or channel) of a transistor. In other words, a partial region of the second semiconductor pattern SC2 may be a semiconductor region of a transistor, another partial region thereof may be a source region SE2/drain region DE2 of a transistor, and still another partial region thereof may be a signal transmission region.

A fourth insulating layer 40 may be disposed on the third insulating layer 30. As illustrated in FIG. 6, the fourth insulating layer 40 may cover the second semiconductor pattern SC2. In an embodiment of the disclosure, the fourth insulating layer 40 may overlap a gate GT2 of the oxide transistor O-TFT and be an insulating pattern exposed by the source region SE2 and drain region DE2 of the oxide transistor O-TFT.

The gate GT2 of the oxide transistor O-TFT may be disposed on the fourth insulating layer 40. The gate GT2 of the oxide transistor O-TFT may be a portion of a metal pattern. The gate GT2 of the oxide transistor O-TFT may overlap the channel region AC2.

A fifth insulating layer 50 may be disposed on the fourth insulating layer 40, and the fifth insulating layer 50 may cover the gate GT2. Each of the first to fifth insulating layers 10 to 50 may be an inorganic layer.

A first connection pattern CNP1 may be disposed on the fifth insulating layer 50. The first connection pattern CNP1 may be electrically connected to the drain region DE1 of the silicon transistor S-TFT through a contact hole passing through the first to fifth insulating layers 10, 20, 30, 40, and 50.

A sixth insulating layer 60 may be disposed on the fifth insulating layer 50. A second connection pattern CNP2 may be disposed on the sixth insulating layer 60. The second connection pattern CNP2 may be electrically connected to the first connection pattern CNP1 through a contact hole passing through the sixth insulating layer 60. A data line DL may be disposed on the sixth insulating layer 60. A seventh insulating layer 70 may be disposed on the sixth insulating layer 60 and cover the second connection pattern CNP2 and the data line DL. Since the second connection pattern CNP2 and the data line DL may be formed through a same process, they may have a same material and a same stacked structure. Each of the sixth insulating layer 60 and the seventh insulating layer 70 may be an organic layer.

The first shielding electrode BMI,a, the gate GT1 of the silicon transistor S-TFT, the second electrode CE20, and the gate GT2 of the oxide transistor O-TFT may include molybdenum (Mo), an alloy containing molybdenum, titanium (Ti), an alloy containing titanium, or a combination thereof which have good heat resistance. The first connection pattern CNP1 and the second connection pattern CNP2 may include aluminium which has high electrical conductivity. The first connection pattern CNP1 and the second connection pattern CNP2 may have a three-layer stacked structure of titanium/aluminium/titanium.

The light-emitting element LD may include an anode AE (or first electrode), a light-emitting layer EL, and a cathode CE (or second electrode). The anode AE of the light-emitting element LD may be disposed on the seventh insulating layer 70. The anode AE may be a (semi)transmissive electrode or a reflective electrode. The anode AE may include a stacked structure of ITO/Ag/ITO which may be sequentially stacked on each other. The positions of the anode AE and the cathode CE may be changed with each other.

A pixel defining film PDL may be disposed on the seventh insulating layer 70. The pixel defining film PDL may be an organic layer. The pixel defining film PDL may have a property of absorbing light. For example, the pixel defining film PDL may have a black color. The pixel defining film PDL may include a black coloring agent. The black coloring agent may include a black dye and a black pigment. The black coloring agent may include carbon black, a metal such as chromium, or an oxide thereof. The pixel defining film PDL may correspond to a light blocking pattern having a property of blocking light.

The pixel defining film PDL may cover a portion of the anode AE. For example, an opening PDL-OP exposing a portion of the anode AE may be defined in the pixel defining film PDL. A light-emitting region LA may be defined to correspond to the opening PDL-OP. In an embodiment of the disclosure, a hole control layer may be disposed between the anode AE and the light-emitting layer EL. The hole control layer may include a hole transport layer and may further include a hole injection layer. An electron control layer may be disposed between the light-emitting layer EL and the cathode CE. The electron control layer may include an electron transport layer and may further include an electron injection layer.

The encapsulation layer 140 may cover the light-emitting element LD. The encapsulation layer 140 may include an inorganic encapsulation layer 141, an organic encapsulation layer 142, and an inorganic encapsulation layer 143 which may be sequentially stacked on each other, but layers constituting the encapsulation layer 140 are not necessarily limited thereto. The inorganic encapsulation layers 141 and 143 may include a silicon nitride layer, a silicon oxynitride layer, a silicon oxide layer, a titanium oxide layer, an aluminium oxide layer, the like, or a combination thereof. Each of the inorganic encapsulation layers 141 and 143 may have a multi-layered structure. The organic encapsulation layer 142 may include an acrylic-based organic layer, but is not limited thereto.

The input sensor ISL may include at least one conductive layer (or at least one sensor conductive layer) and at least one insulating layer (or at least one sensor insulating layer). In this embodiment, the input sensor ISL may include a first insulating layer 210 (or a first sensor insulating layer), a first conductive layer 220, a second insulating layer 230 (or a second sensor insulating layer), a second conductive layer 240, and a third insulating layer 250 (or a third sensor insulating layer). FIG. 6 illustrates a conductive line of the first conductive layer 220 and a conductive line of the second conductive layer 240.

The first insulating layer 210 may be disposed (e.g., directly disposed) on the display panel DP. The first insulating layer 210 may be an inorganic layer containing at least one of silicon nitride, silicon oxynitride, silicon oxide, or a combination thereof. Each of the first conductive layer 220 and the second conductive layer 240 may have a single-layered structure or a multi-layered structure in which layers may be stacked on each other in the third direction DR3. The first conductive layer 220 and the second conductive layer 240 may include conductive lines defining a mesh-shaped electrode. The conductive line of the first conductive layer 220 and the conductive line of the second conductive layer 240 may or may not be electrically connected to each other through a contact hole passing through the second insulating layer 230. The connection relationship between the conductive line of the first conductive layer 220 and the conductive line of the second conductive layer 240 may be determined depending on a type of sensor forming the input sensor ISL.

The first conductive layer 220 and the second conductive layer 240 which have a single-layered structure may include a metal layer or a transparent conductive layer. The metal layer may include molybdenum, silver, titanium, copper, aluminium, an alloy thereof, or a combination thereof. The transparent conductive layer may include a transparent conductive oxide such as an indium tin oxide (ITO), an indium zinc oxide (IZO), a zinc oxide (ZnOₓ), an indium zinc tin oxide (IZTO), the like, or a combination thereof. The transparent conductive layer may include a conductive polymer such as PEDOT, metal nanowire, graphene, and the like.

The first conductive layer 220 and the second conductive layer 240 which have a multi-layered structure may include metal layers. The metal layers may have, for example, a three-layer structure of titanium/aluminium/titanium. A multi-layered conductive layer may include at least one metal layer and at least one transparent conductive layer. The second insulating layer 230 may be disposed between the first conductive layer 220 and the second conductive layer 240. The third insulating layer 250 may cover the second conductive layer 240. In an embodiment of the disclosure, the third insulating layer 250 may be omitted. The second insulating layer 230 and the third insulating layer 250 may include an inorganic layer or an organic layer.

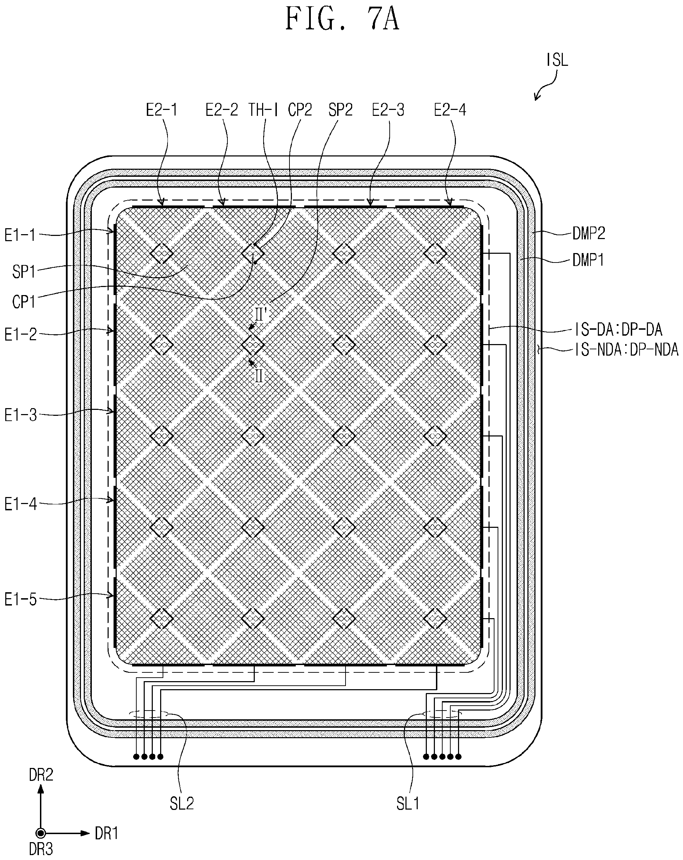

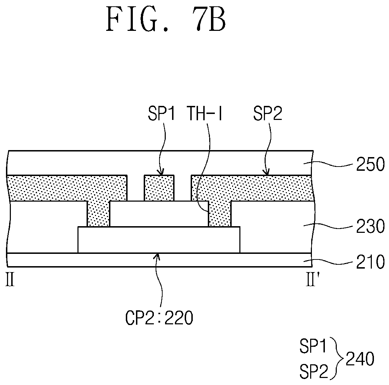

FIG. 7A is a plan view of the input sensor ISL according to an embodiment of the disclosure. FIG. 7B is a schematic cross-sectional view of the input sensor ISL corresponding to II-II' in FIG. 7A.

As illustrated in FIG. 7A, the input sensor ISL includes a sensing region IS-DA and a non-sensing region IS-NDA adjacent to the sensing region IS-DA. The sensing region IS-DA and the non-sensing region IS-NDA respectively correspond to the display region DP-DA and the non-display region DP-NDA illustrated in FIG. 5. The input sensor ISL includes first electrodes E1-1 to E1-5 (or first sensing electrodes), second electrodes E2-1 to E2-4 (or second sensing electrodes), first signal lines SL1 (or first sensor signal lines), and second signal lines SL2 (or second sensor signal lines). The first and second insulating patterns DMP1 and DMP2 may be additionally illustrated in FIG. 7A in order to show the relative positions of the first and second insulating patterns DMP1 and DMP2 with respect to the input sensor ISL.

The first electrodes E1-1 to E1-5 and the second electrodes E2-1 to E2-4, which may be insulated from and cross each other, may be disposed in the sensing region IS-DA. The first signal lines SL1 electrically connected to the first electrodes E1-1 to E1-5 and the second signal lines SL2 electrically connected to the second electrodes E2-1 to E2-4 may be disposed in the non-sensing region IS-NDA. Any one of the first signal line SL1 and the second signal line SL2 transmits a driving signal for sensing an external input from an external circuit to corresponding electrodes, and the other one thereof outputs a sensing signal. Based on the sensing signal, a change in capacitance between the first electrodes E1-1 to E1-5 and the second electrodes E2-1 to E2-4 may be measured. In this embodiment, a mutual cap type input sensor may be illustrated as an example, but the embodiment of the disclosure is not limited thereto. A self-cap type input sensor may also be applied. The self-cap type input sensor may include a type of sensing electrodes.

Each of the first electrodes E1-1 to E1-5 and the second electrodes E2-1 to E2-4 may have a mesh shape having multiple openings defined therein. The openings may be defined to correspond to the light-emitting region LA (see FIG. 6) of the display panel DP. FIG. 6 illustrates an opening E-OP corresponding to one light-emitting region. The second electrodes E2-1 to E2-4 may be insulated from and cross the first electrodes E1-1 to E1-5. Any one of the first electrodes E1-1 to E1-5 and the second electrodes E2-1 to E2-4 may have an integral shape. In this embodiment, the first electrodes E1-1 to E1-5 having an integral shape may be illustrated as an example. The first electrodes E1-1 to E1-5 may include sensing patterns SP1 and intermediate portions CP1.

Each of the second electrodes E2-1 to E2-4 may include sensing patterns SP2 and bridge patterns CP2 (or connection patterns). Two adjacent sensing patterns SP2 may be electrically connected to two bridge patterns CP2, but the number of bridge patterns is not limited thereto.

Referring to FIGS. 6 to 7B, the bridge patterns CP2 may be formed from the first conductive layer 220, and the first electrodes E1-1 to E1-5 and the sensing patterns SP2 may be formed from the second conductive layer 240. The bridge pattern CP2 may be electrically connected to the sensing patterns SP2 through a contact hole TH-I formed in the second insulating layer 230.

In this embodiment, each of the first signal lines SL1 and the second signal lines SL2 of FIG. 7A may be formed from the first conductive layer 220 of FIG. 6. Accordingly, each of the first signal lines SL1 and the second signal lines SL2 of FIG. 7A may be disposed on the same layer as the bridge pattern CP2 of FIG. 7B. Without being limited thereto, however, each of the first signal lines SL1 and the second signal lines SL2 may be formed from the second conductive layer 240. Each of the first signal lines SL1 and the second signal lines SL2 may include both a line formed from the first conductive layer 220 and a line formed from the second conductive layer 240.

FIG. 8 is an enlarged plan view of a non-display region DP-NDA of the display module DM according to an embodiment of the disclosure.

The display region DP-DA and non-display region DP-NDA of the display module DM in FIG. 8 refer to the same reference numerals as the display region DP-DA and non-display region DP-NDA of the display panel DP in FIG. 5. The display region DP-DA and the non-display region DP-NDA may respectively correspond to the sensing region IS-DA and the non-sensing region IS-NDA of FIG. 7A. In the display region DP-DA of FIG. 8, an electrode E1-5 among the first electrodes E1-1 to E1-5 illustrated in FIG. 7A and some electrodes E2-1 to E2-3 among the second electrodes E2-1 to E2-4 illustrated in FIG. 7A may be illustrated, and the components of the display panel DP in the display region DP-DA may be omitted.

Based on FIGS. 5 and 7A, FIG. 8 illustrates an enlargement of a corner region CA (or vertex region) and a portion of the non-display region DP-NDA disposed below the display region DP-DA in a plan view. Among the components illustrated in FIG. 8, components overlapping each other may be disposed on different layers.

The first power line PL1 and the second power line PL2 may be disposed in the non-display region DP-NDA. The first power line PL1 may extend through the corner region CA to the left side of the non-display region DP-NDA illustrated in FIG. 5. The boundary line between the display region DP-DA and the non-display region DP-NDA in the corner region CA may substantially have a curve in a plan view. In FIG. 8, the boundary line between the display region DP-DA and the non-display region DP-NDA may be illustrated as a dotted line.

The first power line PL1 may pass through the left side of the non-display region DP-NDA illustrated in FIG. 5 and extend to the upper side of the non-display region DP-NDA and the right side of the non-display region DP-NDA. The second power line PL2 may be disposed in the non-display region DP-NDA disposed below the display region DP-DA in a plan view and extend in the first direction DR1. The first power line PL1 and the second power line PL2 may be disposed on the same layer as the second connection pattern CNP2 illustrated in FIG. 6.

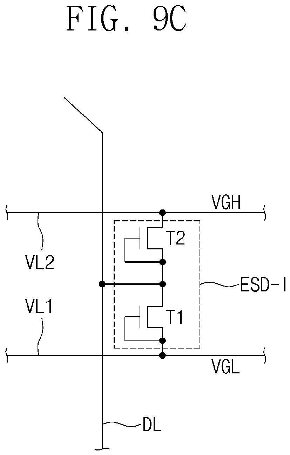

A first voltage line VL1 and a second voltage line VL2 may be disposed in the non-display region DP-NDA. FIG. 8 illustrates one first voltage line VL1 and one second voltage line VL2, but the embodiment of the disclosure is not limited thereto, and the first voltage line VL1 and the second voltage line VL2 may be provided in plurality. The first voltage line VL1 may receive a first voltage VGL (see FIG. 9C) and the second voltage line VL2 may receive a second voltage VGH (see FIG. 9C) higher than the first voltage VGL. In an embodiment of the disclosure, the first voltage VGL may be a first power voltage, and the second voltage VGH may be a second power voltage.

Each of the first voltage line VL1 and the second voltage line VL2 may include a portion extending in the second direction DR2 and a portion extending in the first direction DR1. The first voltage line VL1 and the second voltage line VL2 do not overlap the second power line PL2 and may be disposed lower than the second power line PL2 in a plan view. The first voltage line VL1 and the second voltage line VL2 may be disposed adjacent to an edge EG of the display module DM disposed lower than the second power line PL2 in a plan view. The edge EG of the display module DM may be an edge 110-EG of the base layer 110 illustrated in FIG. 8. The first power line PL1 and the second power line PL2 may be disposed on the same layer as the second connection pattern CNP2 illustrated in FIG. 6, or may be disposed on the same layer as the first connection pattern CNP1.

At least one control signal line CSL may be disposed in the non-display region DP-NDA. The control signal line CSL may be electrically connected to the scan driving circuit SDC illustrated in FIG. 5 through the corner region CA. The control signal line CSL may overlap the first power line PL1. The control signal line CSL may be disposed on the same layer as any one of the first shielding electrode BMI,a, the gate GT1 of the silicon transistor S-TFT, the second electrode CE20, and the gate GT2 of the oxide transistor O-TFT illustrated in FIG. 6.

The data lines DL may be disposed in the display region DP-DA and the non-display region DP-NDA. Some of the data lines DL overlapping the display region DP-DA may be disposed on the same layer as any one of the first connection pattern CNP1 and the second connection pattern CNP2 illustrated in FIG. 6. Some of the data lines DL overlapping the non-display region DP-NDA may be disposed on the same layer as any one of the first shielding electrode BMI,a, the gate GT1 of the silicon transistor S-TFT, the second electrode CE20, and the gate GT2 of the oxide transistor O-TFT. Some of the data lines DL overlapping the display region DP-DA and some of the data lines DL overlapping the non-display region DP-NDA may be electrically connected to each other through a contact hole passing through a corresponding insulating layer among the insulating layers 10br to 70 illustrated in FIG. 6.

The second signal lines SL2 may be disposed in the non-display region DP-NDA. The second signal lines SL2 may overlap the control signal line CSL and the first or second power line PL1 or PL2. Each of the second signal lines SL2 may be electrically connected to a corresponding electrode among the second electrodes E2-1 to E2-3 disposed in the display region DP-DA.

As described above, the base layer 110 may include a first base portion 110-1 and a second base portion 110-2. The first base portion 110-1 may include the display region DP-DA, and the second base portion 110-2 may protrude from the first base portion 110-1 in the second direction DR2. A second edge 110-EG2 of the second base portion 110-2 may protrude more in the second direction DR2 than a first edge 110-EG1 of the first base portion 110-1.

At least some of the data lines DL may extend to the second base portion 110-2. Some of the data lines DL extending to the second base portion 110-2 may be electrically connected to an electrostatic protection circuit ESD. The electrostatic protection circuit ESD may be disposed on the second base portion 110-2. The electrostatic protection circuit ESD may be electrically connected to each of the data lines DL extending to the second base portion 110-2. The electrostatic protection circuit ESD may include multiple electrostatic protection circuit portions ESU arranged in the first direction DR1. Although FIG. 8 illustrates four electrostatic protection circuit portions ESU as an example, the electrostatic protection circuit ESD may include more than four electrostatic protection circuit portions ESU. For example, the electrostatic protection circuit ESD may include 11 electrostatic protection circuit portions ESU.

The data lines DL may cross the first voltage line VL1, the second voltage line VL2, and the second power line PL2. An additional electrostatic protection circuit ESD-I electrically connected to the data line DL, the first voltage line VL1, and the second voltage line VL2 may be disposed in the non-display region DP-NDA. The additional electrostatic protection circuit ESD-I may be disposed adjacent to the first voltage line VL1 and the second voltage line VL2. The additional electrostatic protection circuit ESD-I may be disposed in the non-display region DP-NDA, and when compared to the electrostatic protection circuit ESD, the additional electrostatic protection circuit ESD-I may be disposed adjacent to the display region DP-DA. Although one additional electrostatic protection circuit ESD-I may be illustrated as an example in FIG. 8, an additional electrostatic protection circuit ESD-I may be electrically connected to each data line DL, and multiple additional electrostatic protection circuits ESD-I may be respectively electrically connected to the data lines DL.

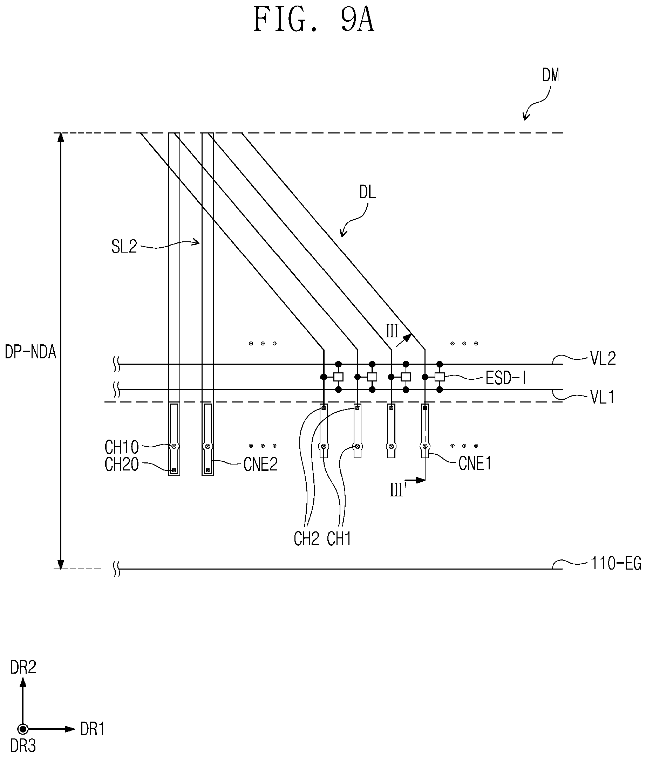

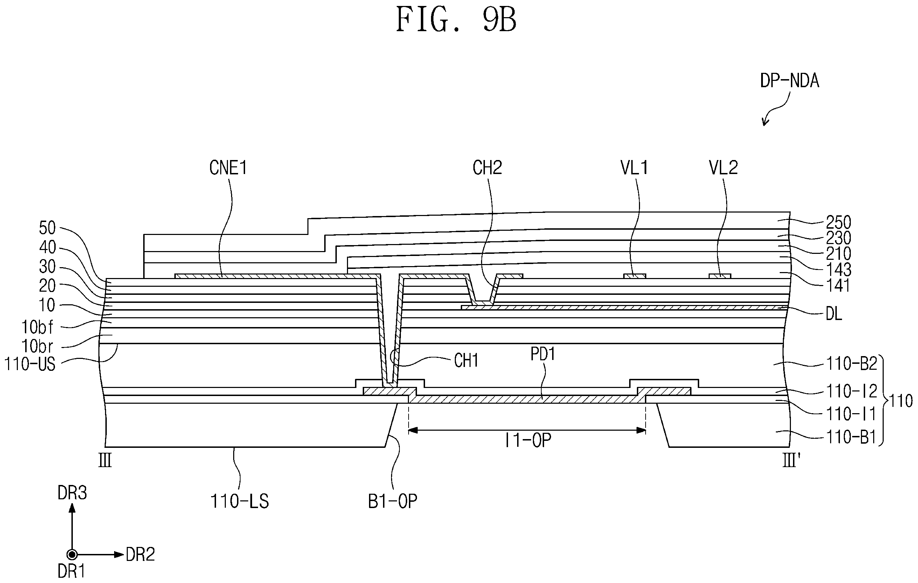

FIG. 9A is an enlarged plan view of the non-display region DP-NDA of the display module DM according to an embodiment of the disclosure. FIG. 9B is a schematic cross-sectional view of the display module DM corresponding to line III-III' of FIG. 9A. FIG. 9C is a circuit diagram of the additional electrostatic protection circuit ESD-I illustrated in FIG. 9A.

FIG. 9A illustrates an enlarged portion of the non-display region DP-NDA illustrated in FIG. 8. Specifically, FIG. 9A illustrates a planar arrangement of some of the data lines DL, some of the second signal lines SL2, and first and second connection electrodes CNE1 and CNE2 electrically connected thereto.

A first voltage line VL1 and a second voltage line VL2 may be disposed in the non-display region DP-NDA. An additional electrostatic protection circuit ESD-I may be disposed in the non-display region DP-NDA. The first connection electrodes CNE1 and the second connection electrodes CNE2 may be disposed in the non-display region DP-NDA. The first connection electrodes CNE1 may be disposed in a one-to-one correspondence with the data lines DL, and the second connection electrodes CNE2 may be disposed in a one-to-one correspondence with the second signal lines SL2.

Referring to FIGS. 9A and 9B, the connection relationship between the first connection electrode CNE1 and a first pad electrode PD1 will be described in detail. The first connection electrode CNE1 in FIG. 9B may be disposed on the same layer as the first connection pattern CNP1 in FIG. 6, and a portion of the data line DL overlapping the non-display region DP-NDA may be disposed on the same layer as the gate GT1 of the silicon transistor S-TFT of FIG. 6.

The first pad electrode PD1 of FIG. 9B is disposed at each first connection electrode CNE1 of FIG. 9A. Multiple first pad electrodes PD1 may be disposed to be spaced apart from each other in the first direction DR1 to correspond to the arrangement of the first connection electrodes CNE1 of FIG. 9A.

A first opening B1-OP may commonly expose multiple first pad electrodes PD1. One first opening B1-OP exposes the first pad electrodes PD1 and regions between them to the outside. In contrast, a second opening I1-OP may be formed separately for each of the first pad electrodes PD1. Without being limited thereto, however, like the second opening I1-OP, the first opening B1-OP may also be formed separately for each of the first pad electrodes PD1. In the case that the first opening B1-OP is formed separately for each of the first pad electrodes PD1, a portion of a first synthetic resin layer 110-B1 may be disposed between the first pad electrodes PD1.

The first pad electrode PD1 may be exposed to the outside through a lower surface 110-LS of the base layer 110 for backside bonding with the flexible circuit board FCB (see FIG. 2). The lower surface 110-LS of the base layer 110 faces an upper surface 110-US of the base layer 110 in the third direction DR3. The lower surface 110-LS of the base layer 110 corresponds to the rear surface of the display panel DP (see FIG. 5).

FIG. 9B illustrates the arrangement relationship between the base layer 110 and the first pad electrode PD1 according to an embodiment of the disclosure. In this embodiment, the first pad electrode PD1 may be embedded in the base layer 110. Without being limited thereto, however, the first pad electrode PD1 may be disposed on the lower surface 110-LS of the base layer 110. The base layer 110 may include a single-layered synthetic resin layer, or although the base layer 110 may include multiple layers, the first opening B1-OP and the second opening I1-OP, which will be described later, may not be defined.

As illustrated in FIG. 9B, the base layer 110 may include a first synthetic resin layer 110-B1, a first inorganic base layer 110-I1, a second inorganic base layer 110-I2, and a second synthetic resin layer 110-B2. The first synthetic resin layer 110-B1 provides the lower surface 110-LS of the base layer 110, and the first synthetic resin layer 110-B1 has a first opening B1-OP defined therein and exposing the first pad electrode PD1. The first inorganic base layer 110-I1 may be disposed on the first synthetic resin layer 110-B1, exposes the first pad electrode PD1, and has a second opening I1-OP defined therein and corresponding to the first opening B1-OP. The second inorganic base layer 110-I2 may be disposed on the first inorganic base layer 110-I1 and may cover the first pad electrode PD1. The second synthetic resin layer 110-B2 may be disposed on the second inorganic base layer 110-I2. The first synthetic resin layer 110-B1 and the second synthetic resin layer 1 10-B2 may include polyimide, and the first inorganic base layer 110-I1 and the second inorganic base layer 110-I2 may include silicon nitride, silicon oxide, silicon oxynitride, or a combination thereof.

The first connection electrode CNE1 may be electrically connected to the first pad electrode PD1 through a first contact hole CH1 and electrically connected to the data line DL through a second contact hole CH2. The first contact hole CH1 may pass through corresponding insulating layers 10br to 50 among the insulating layers and extend to the base layer 110. In this embodiment, the first contact hole CH1 may pass through from the barrier layer 10br to the fifth insulating layer 50. The first contact hole CH1 may further pass through the second inorganic base layer 110-I2 and the second synthetic resin layer 110-B2 below the barrier layer 10br. The second contact hole CH2 may pass through from the second insulating layer 20 to the fifth insulating layer 50.

With reference to FIGS. 9A and 9B, a structure in which the first connection electrode CNE1 connects the data line DL and the first pad electrode PD1 to each other may be described as an example. The arrangement relationship between the first connection electrode CNE1 and the first pad electrode PD1 may be equally applied to other signal lines illustrated in FIG. 8. For example, the first connection electrode CNE1 and the first pad electrode PD1 may be disposed to correspond to the control signal line CSL, the first voltage line VL1, the second voltage line VL2, the first power line PL1, and the second power line PL2 of FIG. 8. A first pad electrode PD1 may be disposed for each signal line, and multiple first pad electrodes PD1 may be arranged in the first direction DR1 in FIGS. 8 and 9A. Multiple first pad electrodes PD1 may be disposed on some signal lines, for example, the first power line PL1 and the second power line PL2.

FIG. 9A illustrates that the first connection electrodes CNE1 may have a same shape and arrangement as each other, but the embodiment of the disclosure is not limited thereto, and each of the first connection electrodes CNE1 may have a different shape and arrangement. For example, the positions of the first contact holes CH1 defined in the first connection electrodes CNE1 may be different from each other. More specifically, adjacent first contact holes CH1 may be arranged in a zigzag manner in the first direction DR1.

The second connection electrode CNE2 may connect the second signal line SL2 and a second pad electrode (not illustrated), and the second pad electrode may be substantially the same as the first pad electrode PD1 described with reference to FIG. 9B. The second pad electrode and the first pad electrode PD1 have a same material and a same stacked structure. The second pad electrode may be exposed to the outside through the lower surface 110-LS of the base layer 110 for backside bonding with the flexible circuit board FCB (see FIG. 2). The second pad electrode may be embedded in the base layer 110 like the first pad electrode PD1.

The second connection electrode CNE2 may be electrically connected to the second pad electrode. The second connection electrode CNE2 may be electrically connected to the second pad electrode through a third contact hole CH10. The second connection electrode CNE2 may be electrically connected to the second pad electrode through the third contact hole CH10 passing through corresponding insulating layers among the insulating layers.

The second signal lines SL2 may be electrically connected to the second connection electrode CNE2. The second signal lines SL2 may be electrically connected to the second connection electrode CNE2 through a fourth contact hole CH20 passing through corresponding insulating layers among the insulating layers and the insulating layers 210, 230, and 250 of the input sensor ISL.

Referring to FIG. 9C, the additional electrostatic protection circuit ESD-I may include a first transistor T1 diode-connected from the first voltage line VL1 to the data line DL and a second transistor T2 diode-connected from the data line DL to the second voltage line VL2. The first voltage line VL1 may receive a first voltage VGL, and the second voltage line VL2 may receive a second voltage VGH higher than the first voltage VGL.

The source or drain of the first transistor T1 may be electrically connected to the gate of the first transistor T1, and the source or drain of the second transistor T2 may be electrically connected to the gate of the second transistor T2. The first transistor T1 and the second transistor T2 may have the same stacked structure as the silicon transistor S-TFT illustrated in FIG. 6. For example, a connection pattern disposed on a same layer as the first connection pattern CNP1 illustrated in FIG. 6 may connect the gate of the first transistor T1 and the source or drain of the first transistor T1 to each other. The first voltage line VL1 may be disposed on the same layer as the second connection pattern CNP2 illustrated in FIG. 6. The first voltage line VL1 may be electrically connected to the connection pattern connecting the gate of the first transistor T1 and the source or drain of the first transistor T1. In an embodiment of the disclosure, the first voltage line VL1 disposed on the same layer as the first connection pattern CNP1 illustrated in FIG. 6 may be electrically connected to the gate of the first transistor T1 and the source or drain of the first transistor T1.

In the case that a voltage higher than the second voltage VGH is applied to the data line DL due to static electricity, the second transistor T2 may be turned on and lets current flow to the second voltage line VL2. Accordingly, the voltage of the data line DL decreases. On the contrary, in the case that a voltage lower than the first voltage VGL may be applied to the data line DL, the first transistor T1 may be turned on so that current flows from the first voltage line VL1 to the data line DL. Accordingly, the voltage of the data line DL increases. Accordingly, the voltage of the data line DL may be maintained at a level between the first voltage VGL and the second voltage VGH. Accordingly, a circuit electrically connected to the data line DL may be protected from static electricity.

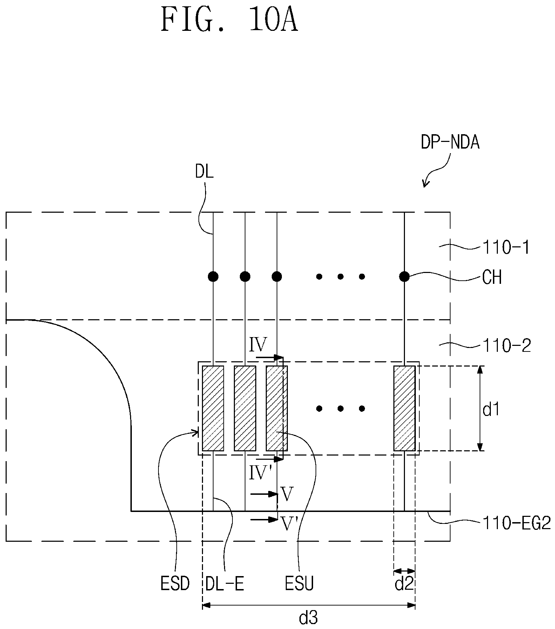

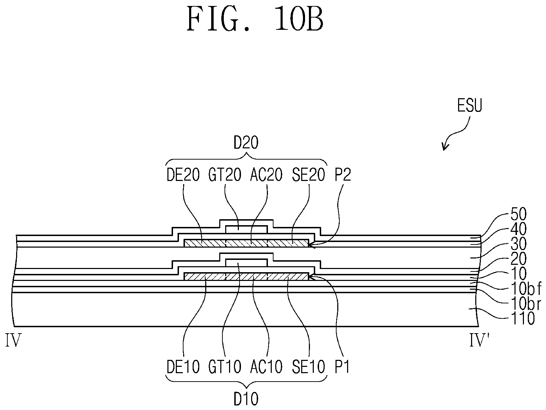

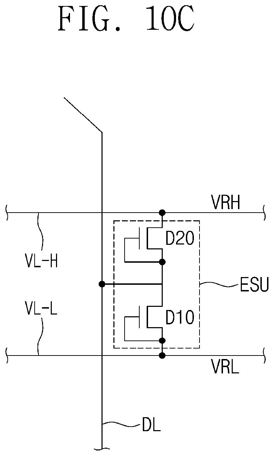

FIG. 10A is an enlarged plan view of the non-display region DP-NDA of the display module DM according to an embodiment of the disclosure. FIG. 10B is a schematic cross-sectional view of the display module DM corresponding to line IV-IV' of FIG. 10A. FIG. 10B illustrates a cross section of the electrostatic protection circuit portion ESU among the components of the display module. FIG. 10C is a circuit diagram of the electrostatic protection circuit portion ESU illustrated in FIG. 10B.

FIG. 10A illustrates an enlarged portion of the non-display region DP-NDA illustrated in FIG. 8. Specifically, FIG. 10A illustrates a shape in which the data line DL extends to the second base portion 110-2, and a planar arrangement of the electrostatic protection circuit ESD electrically connected to the data line DL.

Referring to FIG. 10A, as described above, the base layer 110 may include a first base portion 110-1 and a second base portion 110-2, and at least some of the data lines DL may extend to the second base portion 110-2. Some of the data lines DL extending to the second base portion 110-2 may be electrically connected to the electrostatic protection circuit ESD.

The data lines DL may be electrically connected to the above-described first pad electrode PD1 (see FIG. 9B) and first connection electrode CNE1 (see FIG. 9B) through a contact hole CH. FIG. 10A briefly illustrates the electrical connection relationship between the data lines DL and the first pad electrode PD1 (see FIG. 9B) and the first connection electrode CNE1 (see FIG. 9B), but a structure indicated as the contact hole CH may have the connection structure including the above-described first contact hole CH1 (see FIG. 9B), second contact hole CH2 (see FIG. 9B), and first connection electrode CNE1 (see FIG. 9B).

The electrostatic protection circuit ESD may be disposed on the second base portion 110-2. The electrostatic protection circuit ESD may be electrically connected to each of the data lines DL extending to the second base portion 110-2. The electrostatic protection circuit ESD may include multiple electrostatic protection circuit portions ESU arranged in the first direction DR1. Although FIG. 10A illustrates four electrostatic protection circuit portions ESU as an example, the electrostatic protection circuit ESD may include more than four electrostatic protection circuit portions ESU. For example, the electrostatic protection circuit ESD may include 11 electrostatic protection circuit portions ESU.

The data line DL electrically connected to the electrostatic protection circuit ESD may extend to the second edge 110-EG2 of the second base portion 110-2. In this specification, a portion of the data line DL extending to the second edge 110-EG2 of the second base portion 110-2 may be referred to as an extension portion DL-E.

Referring to FIGS. 10A and 10B, each of the electrostatic protection circuit portions ESU included in the electrostatic protection circuit ESD includes a first diode D10 and a second diode D20. Each of the first diode D10 and the second diode D20 may be disposed in the non-display region DP-NDA.

The first diode D10 and the second diode D20 may be disposed to overlap each other in a plan view. The second diode D20 may be disposed on the first diode D10, and at least a portion of the second diode D20 overlaps at least a portion of the first diode D10 in a plan view.

The first diode D10 may include a silicon semiconductor, and the second diode D20 may include an oxide semiconductor. The first diode D10 may include, for example, amorphous silicon, polycrystalline silicon, the like, or a combination thereof. The first diode D10 may include low-temperature polysilicon. The second diode D20 may include a transparent conductive oxide (TCO) such as an indium tin oxide (ITO), an indium zinc oxide (IZO), an indium gallium zinc oxide (IGZO), a zinc oxide (ZnOₓ), an indium oxide (In₂O₃), or a combination thereof.

The first diode D10 may include a first pattern P1, and a source region SE10, a channel region AC10 (or active region), and a drain region DE10 may be formed in the first pattern P1. The first pattern P1 and the first semiconductor pattern SC1 (see FIG. 6) of the aforementioned silicon transistor S-TFT (see FIG. 6) may include a same material. The first pattern P1 and the first semiconductor pattern SC1 (see FIG. 6) may be disposed on a same layer and may be formed through a same process. For example, the first pattern P1 may be disposed on the buffer layer 10bf. The first pattern P1 may be disposed below and covered by the first insulating layer 10. In this specification, the first insulating layer 10 may be referred to as a "first inorganic insulating layer." The first diode D10 may further include a gate GT10, and the gate GT10 may be disposed on the first insulating layer 10. The gate GT10 may be a portion of a metal pattern. The gate GT10 may overlap the channel region AC10.

The first pattern P1 may include a silicon semiconductor. For example, the silicon semiconductor may include amorphous silicon, polycrystalline silicon, the like, or a combination thereof. For example, the first pattern P 1 may include low-temperature polysilicon.

The second diode D20 may include a second pattern P2, and a source region SE20, a channel region AC20 (or active region), and a drain region DE20 may be formed in the second pattern P2. The second semiconductor pattern SC2 (see FIG. 6) of the aforementioned oxide transistor O-TFT (see FIG. 6) and the second pattern P2 may include a same material. The second pattern P2 and the second semiconductor pattern SC2 (see FIG. 6) may be disposed on a same layer and may be formed through a same process. For example, the second pattern P2 may be disposed on the third insulating layer 30. The second pattern P2 may be disposed above the first to third insulating layers 10 to 30. The second pattern P2 may be disposed below and covered by the fourth insulating layer 40. The second diode D20 may further include a gate GT20, and the gate GT20 may be disposed on the fourth insulating layer 40. The gate GT20 may be a portion of a metal pattern. The gate GT20 may overlap the channel region AC20.

Each of the first pattern P1 of the first diode D10 and the second pattern P2 of the second diode D20 may be electrically connected to the data line DL. At least one voltage line may be diode-connected to each of the first diode D10 and the second diode D20 included in the electrostatic protection circuit portion ESU. For example, as illustrated in FIG. 10C, the first diode D10 may be electrically connected from a first reference voltage line VL-L to the data line DL, and the second diode D20 may be electrically connected from the data line DL to a second reference voltage line VL-H. The reference voltage lines VL-L and VL-H may respectively receive reference voltages VRL and VRH (e.g., predetermined or selectable reference voltages VRL and VRH) applied to the electrostatic protection circuit portion ESU.

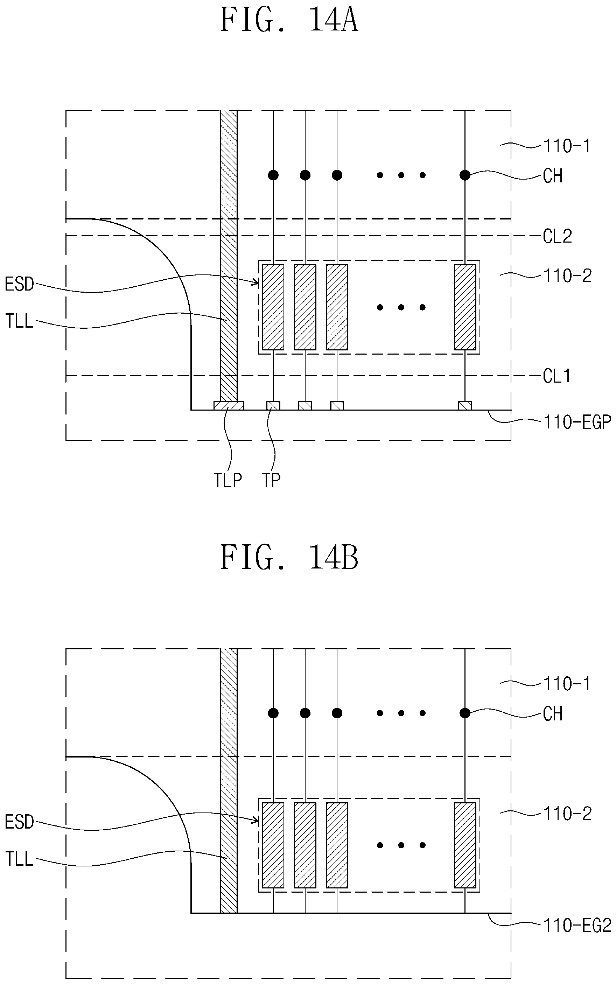

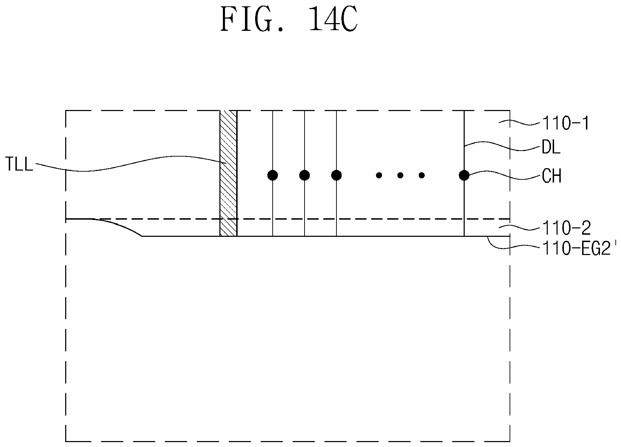

The electrostatic protection circuit portion ESU may perform a buffer function that blocks electrical overload such as static electricity in the case that the electrical overload such as static electricity occurs in a test process which may be performed by applying a voltage (e.g., predetermined or selectable voltage) through a re-test pad TP (see FIG. 14A) which will be described later. For example, in the case that a voltage higher than the voltage of a voltage line is applied to the data line DL due to static electricity or the like during a test, each of the first diode D10 and the second diode D20 may be turned on so that current flows to the voltage line, thus being able to prevent an excessive voltage from being applied to the data line DL. Accordingly, the circuit electrically connected to the data line DL may be protected from static electricity or the like during a test.

More specifically, in a test which may be performed by applying a voltage (e.g., predetermined or selectable voltage) through a re-test pad TP (see FIG. 14A), in the case that a voltage higher than the second reference voltage VRH is applied to the extension portion DL-E of the data line DL due to static electricity or the like, the electrostatic protection circuit portion ESU lets current flow to the second reference voltage line VL-H through the second diode D20. Accordingly, the voltage of the data line DL decreases. On the contrary, in the case that a voltage lower than the first reference voltage VRL is applied to the data line DL, current flows from the first reference voltage line VL-L to the data line DL through the first diode D10. Accordingly, the voltage of the data line DL increases. Therefore, although a high level of static electricity may be generated during a test or a high level of current or voltage may be applied for other reasons, the voltage of the data line DL may be maintained at a level between the first reference voltage VRL and the second reference voltage VRH. Accordingly, the electrostatic protection circuit portion ESU may protect the circuit electrically connected to the data line DL from static electricity during a test.

The first diode D10 and the second diode D20 included in each electrostatic protection circuit portion ESU may be disposed to overlap each other in a plan view. By having a structure in which the first diode D10 including a silicon semiconductor and the second diode D20 including an oxide semiconductor may be vertically disposed and overlap each other, the electrostatic protection circuit portion ESU may decrease an area occupied as compared to an area occupied by a structure in which two diodes are disposed on the same layer. As the electrostatic protection circuit portion ESU includes the first diode D10 and the second diode D20 which may be vertically disposed, the area of a region in which the electrostatic protection circuit ESD may be disposed may be minimized. Accordingly, the area of the non-display region DP-NDA in which the electrostatic protection circuit ESD may be disposed may be reduced.

Referring again to FIG. 10A, a length d1 of the electrostatic protection circuit portion ESU in the second direction DR2 may be in a range of about 200 micrometers to about 300 micrometers. As the electrostatic protection circuit portion ESU has a structure in which the first diode D10 and the second diode D20 may be disposed to overlap each other in a plan view, the length d1 in the second direction DR2 may be reduced to about 300 micrometers or less.

A width d2 of the electrostatic protection circuit portion ESU in the first direction DR1 may be in a range of about 70 micrometers to about 130 micrometers. An overall width d3 of the electrostatic protection circuit ESD including multiple electrostatic protection circuit portions ESU in the first direction DR1 may be in a range of about 900 micrometers to about 1300 micrometers. As the width in the first direction DR1 and the length in the second direction DR2 of the electrostatic protection circuit portion ESU and the electrostatic protection circuit ESD satisfy the aforementioned ranges, the electrostatic protection circuit ESD may protect the circuit electrically connected to the data line DL from static electricity or the like during a test, while minimizing the area of the region in which the electrostatic protection circuit ESD may be disposed.

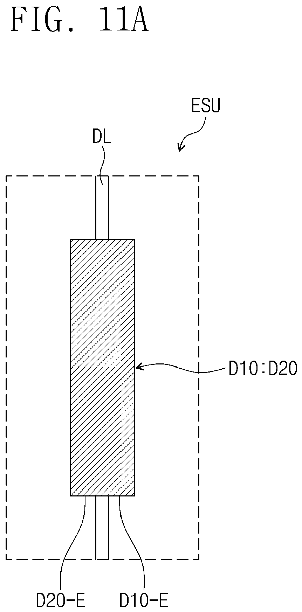

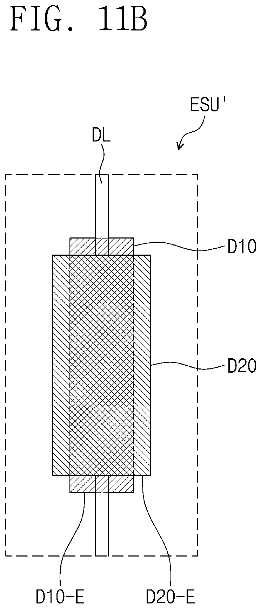

FIGS. 11A and 11B are plan views of electrostatic protection circuit portions ESU and ESU' according to an embodiment of the disclosure.

Referring to FIGS. 10A, 10B, and 11A together, the electrostatic protection circuit portion ESU includes a first diode D10 and a second diode D20, and the first diode D10 and the second diode D20 may be disposed to overlap each other in a plan view. The second diode D20 may be disposed on the first diode D10, and at least a portion of the second diode D20 overlaps at least a portion of the first diode D10 in a plan view.

As illustrated in FIG. 11A, the first diode D10 and the second diode D20 may be disposed to entirely overlap each other in a plan view. As the first diode D10 and the second diode D20 have the same planar area as each other and have the same arrangement position as each other, they may completely overlap each other in a plan view. In the electrostatic protection circuit portion ESU according to an embodiment of the disclosure, a first outer line D10-E of the first diode D10 and a second outer line D20-E of the second diode D20 may be defined to completely overlap each other in a plan view. The first outer line D10-E of the first diode D10 illustrated in FIG. 11A may be the outer line of the above-described first pattern P1, and the second outer line D20-E of the second diode D20 may be the outer line of the above-described second pattern P2.

As illustrated in FIG. 11B, in an electrostatic protection circuit portion ESU' according to an embodiment of the disclosure, in a plan view, the first diode D10 and the second diode D20 may be disposed to partially overlap each other, and remaining portions thereof may be disposed to non-overlap each other. The first outer line D10-E of the first diode D10 and the second outer line D20-E of the second diode D20 may not match each other. The first outer line D10-E of the first diode D10 illustrated in FIG. 11B may be the outer line of the above-described first pattern P1, and the second outer line D20-E of the second diode D20 may be the outer line of the above-described second pattern P2. FIG. 11B illustrates that the second diode D20 has a larger width in the first direction DR1 than the first diode D10 and that the first diode D10 has a larger width in the second direction DR2 than the second diode D20, but the planar shapes and areas of the first diode D10 and the second diode D20 are not limited thereto.

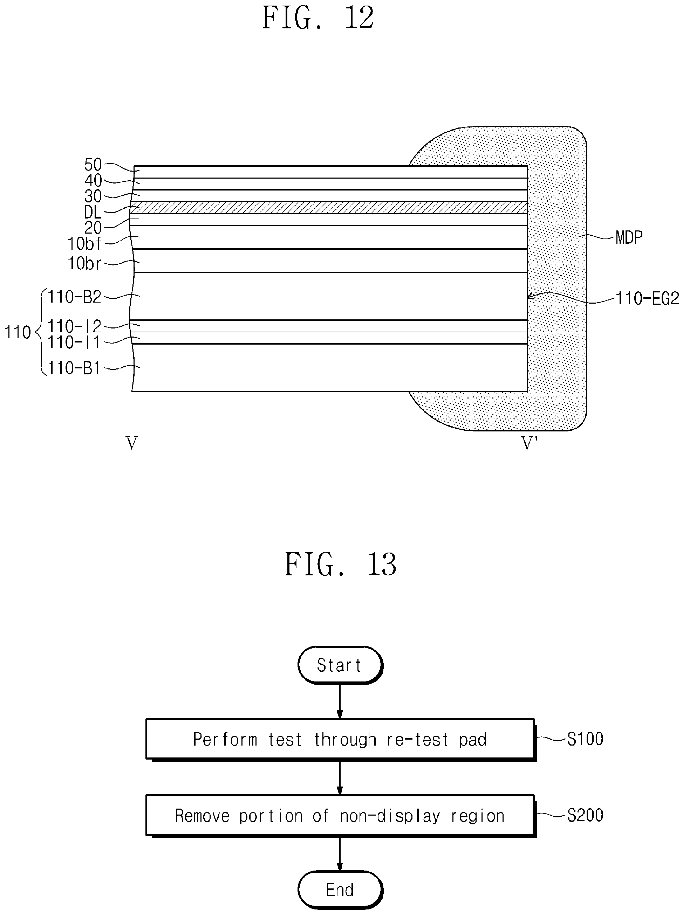

FIG. 12 is a schematic cross-sectional view of the display module DM corresponding to line V-V' of FIG. 10A. FIG. 12 illustrates a cross section corresponding to the second edge 110-EG2 from which the data line DL extends.

Referring to FIGS. 10A and 12, the display module DM according to an embodiment of the disclosure may further include a molding portion MDP. The molding portion MDP may cover the second edge 110-EG2 of the base layer 110. The molding portion MDP may be disposed to cover at least a side surface of the base layer 110. As the molding portion MDP covers the second edge 110-EG2, the data line DL extending to the second edge 110-EG2 may be covered by the molding portion MDP, thereby making it possible to prevent additional static electricity from being generated or to prevent the data line DL from being damaged. The molding portion MDP may contain an acrylic-based resin, and the type of resin may not be particularly limited. The molding portion MDP may include polypropylene, polyethylene, polystyrene, acrylonitrile-styrene, polymethyl methacrylate, or a combination thereof. Although not illustrated, the molding portion MDP may cover not only the display module DM, but also the edges of the lower member LM (see FIG. 3) and the upper member UM (see FIG. 3) disposed on the display module DM.

FIG. 13 is a flowchart showing a method of manufacturing a display device according to an embodiment of the disclosure. FIGS. 14A to 14C are plan views illustrating a step of the method of manufacturing the display device according to an embodiment of the disclosure. FIGS. 14A to 14C illustrate a step in the method of manufacturing the display device in a plan view corresponding to FIG. 10A. Hereinafter, in describing the method of manufacturing the display device according to an embodiment of the disclosure with reference to FIGS. 13 and 14A to 14C, the same reference numerals are assigned to the same components as those described above and detailed descriptions thereof are omitted.

Referring to FIGS. 8 and 13, in the method of manufacturing the display device DD (see FIG. 2) including the display region DP-DA and the non-display region DP-NDA, the method of manufacturing the display device includes performing a test by applying a voltage (e.g., predetermined or selectable voltage) through a re-test pad disposed in the non-display region (S100) and removing a portion of the non-display region (S200).

Referring to FIGS. 8, 13, and 14A, in the method of manufacturing the display device according to an embodiment of the disclosure, the base layer 110 of the display module DM may include a first base portion 110-1 and a second base portion 110-2 as described above, and at least some of the data lines DL may extend to the second base portion 110-2.

The display module DM may be electrically connected to the re-test pad TP electrically connected to the ends of the data lines DL. The re-test pad TP may be disposed adjacent to a preliminary edge 110-EGP, which may be defined as an end of the second base portion 110-2, in a step prior to the removing of a portion of the non-display region. A test may be performed by applying a voltage (e.g., predetermined or selectable voltage) through the re-test pad TP. In a test which may be performed by applying a voltage (e.g., predetermined or selectable voltage) through the re-test pad TP, the electrostatic protection circuit ESD may perform a buffer function to block an electrical overload such as static electricity in the case that the electrical overload such as static electricity occurs. For example, in the case that a voltage higher than the voltage of the voltage line is applied to the data line DL due to static electricity or the like during a test, as each of the first diode D10 (see FIG. 10B) and the second diode D20 (see FIG. 10B), which may be described above, may be turned on and to allow current flow to the voltage line, it may be possible to prevent excessive voltage from being applied to the data line DL. Accordingly, the circuit electrically connected to the data line DL may be protected from static electricity or the like in the case that a test is performed.

The display module DM may further include a lighting pad line TLL extending in parallel with the data line DL. The lighting pad line TLL may be electrically connected to a lighting pad TLP disposed outside the display module DM. The lighting pad TLP may be used to determine whether or not there is a defect in the case that a test is performed through the re-test pad TP. The lighting pad line TLL may have a greater width than the data line DL. For example, the lighting pad line TLL may have a width which may be about 10 times or larger than that of the data line DL.

Cutting lines CL1 and CL2 defined in the second base portion 110-2 may be defined in the display module DM. The cutting lines CL1 and CL2 may be virtual lines on which a cutting process may be performed in the removing of a portion of the non-display region (S200). In the removing of a portion of the non-display region (S200), after the cutting process is performed along the cutting lines CL1 and CL2, a portion below the cutting lines CL1 and CL2 in a plan view may be removed.

Referring to FIGS. 8, 13, 14A, and 14B, in the removing of a portion of the non-display region (S200), a cutting process may be performed along a first cutting line CL1, and a first portion in which the re-test pad TP is disposed may be removed. As the cutting process is performed along the first cutting line CL1, the second edge 110-EG2 of the second base portion 110-2 may be formed. After the removing of a portion of the non-display region (S200), the data line DL may extend to the second edge 110-EG2 of the second base portion 110-2. As the cutting process is performed along the first cutting line CL1, the lighting pad TLP electrically connected to the lighting pad line TLL may be removed together.

Although not illustrated, after the removing of a portion of the non-display region (S200), forming a molding portion to cover at least a portion of the non-display region may be further included. The molding portion MDP (see FIG. 12) may cover the second edge 110-EG2 of the base layer 110. As the method of manufacturing the display device according to an embodiment of the disclosure further includes the forming of a molding portion, the data line DL extending to the second edge 110-EG2 may be covered, thereby preventing additional static electricity from being generated or preventing the data line DL from being damaged.

Referring to FIGS. 8, 13, 14A, and 14C, in the removing of a portion of the non-display region (S200), a cutting process may be performed along the second cutting line CL2, and a first portion in which the re-test pad TP may be disposed and a second portion in which the electrostatic protection circuit ESD may be disposed may be removed together. As the cutting process is performed along the second cutting line CL2, a second edge 110-EG2' of the second base portion 110-2 may be formed. After the removing of a portion of the non-display region (S200), the data line DL may extend to the second edge 110-EG2' of the second base portion 110-2. As the cutting process is performed along the second cutting line CL2, the lighting pad TLP electrically connected to the lighting pad line TLL may also be removed. In the case that the cutting process is performed along the second cutting line CL2, the area of the second base portion 110-2 may be minimized. After the removing of a portion of the non-display region (S200), as described above, the forming of a molding portion MDP (see FIG. 12) covering the second edge 110-EG2' of the base layer 110 may be performed.

According to the disclosure, a flexible circuit board may be coupled to the rear surface of the display panel. Since the non-display region of the display panel may not be bent, it may be possible to prevent a defect that may occur in the case that the non-display region of the display panel is bent. The area of the bezel region of the window to cover the non-display region of the display panel may be reduced.

In order to reduce the non-display region, the electrostatic protection circuit disposed in the non-display region has a structure in which two diodes may be disposed to overlap each other. Accordingly, the area occupied by the electrostatic protection circuit may be minimized, and therefore, the non-display region may be reduced.

Although the above has been described with reference to embodiments of the disclosure, those skilled in the art or those of ordinary skill in the art will understand that various modifications and changes can be made to the disclosure within the scope that does not depart from the technical field of the disclosure described in the claims to be described later. Accordingly, the technical scope of the disclosure should not be limited to the content described in the detailed description of the specification, but should be determined by the claims described hereinafter.

Embodiments are set out in the following clauses:
Clause 1. A display device comprising:
   a display panel including a display region and a non-display region,
   wherein the display panel comprises:
   a base layer overlapping the display region and the non-display region;
   a pad electrode exposed through the lower surface of the base layer;
   a pixel disposed on the upper surface of the base layer and comprising a light-emitting element overlapping the display region and a transistor electrically connected to the light-emitting element;
   a data line disposed on the upper surface of the base layer, overlapping the display region and the non-display region, and electrically connected to the transistor; an electrostatic protection circuit electrically connected to the data line; and
   a connection electrode electrically connecting the data line and the pad electrode to each other in the non-display region,
   wherein the electrostatic protection circuit comprises:
      a first diode disposed in the non-display region; and
      a second diode disposed on the first diode and overlapping at least a portion of the first diode on a plane.
Clause 2. The display device of clause 1, wherein:
   the first diode comprises a silicon semiconductor; and
   the second diode comprises an oxide semiconductor.
Clause 3. The display device of clause 1 or clause 2, wherein the second diode entirely overlaps the first diode.
Clause 4. The display device of any one of clauses 1 to 3, wherein:
   the data line extends along a first direction; and
   a length of the electrostatic protection circuit in the first direction is about 200 micrometers to about 300 micrometers.
Clause 5. The display device any one of clauses 1 to 4, wherein:
   the display panel further comprises a plurality of insulating layers disposed on the upper surface of the base layer; and
   the connection electrode is connected to the pad electrode through a first contact hole, which passes through a corresponding insulating layer among the plurality of insulating layers and is defined in the base layer, and is connected to the data line through a second contact hole passing through a corresponding insulating layer among the plurality of insulating layers.
Clause 6. The display device of clause 5, wherein the base layer comprises:
   a first synthetic resin layer providing the lower surface of the base layer and having a first opening which is defined therein and exposes the pad electrode;
   a first inorganic base layer disposed on the first synthetic resin layer and having a second opening which is defined therein, exposes the pad electrode, and corresponds to the first opening;
   a second inorganic base layer disposed on the first inorganic base layer and covering the pad electrode; and
   a second synthetic resin layer disposed on the second inorganic base layer,
   wherein the first contact hole passes through the second synthetic resin layer and the second inorganic base layer.
Clause 7. The display device any one of clauses 1 to 6, wherein the display panel further comprises an additional electrostatic protection circuit electrically connected to the data line and disposed closer to the display region than the electrostatic protection circuit.
Clause 8. The display device of any one of clauses 5 to 7, wherein the plurality of insulating layers comprise a first inorganic insulating layer,
   wherein:
   at least a portion of the first diode is disposed below the first inorganic insulating layer; and
   the second diode is disposed above the first inorganic insulating layer.
Clause 9. The display device of clause 8, wherein:
   the first diode comprises a first pattern disposed below the first inorganic insulating layer and including a silicon semiconductor; and
   the second diode comprises a second pattern disposed above the first inorganic insulating layer and including an oxide semiconductor.
Clause 10. The display device of clause 9, wherein the first pattern and the second pattern overlap each other on a plane.
Clause 11. The display device any one of clauses 1 to 10, wherein the base layer comprises:
   a first base portion overlapping the display region; and
   a second base portion protruding from the first base portion in a first direction,
   wherein:
      a width of the second base portion in a second direction crossing the first direction is smaller than a width of the first base portion; and
      the electrostatic protection circuit is disposed on the second base portion.
Clause 12. The display device of clause 11, wherein the display panel further comprises a lighting pad line disposed on the second base portion, extending to an end of the second base portion, and having a width greater than that of the data line.
Clause 13. The display device of clause 11 or clause 12, wherein the display panel further comprises a molding portion covering an end of the second base portion.
Clause 14. The display device any one of clauses 1 to 13, wherein:
   the data line extends along a first direction; and
   the electrostatic protection circuit comprises a plurality of electrostatic protection circuit units spaced apart from each other in a second direction crossing the first direction.
Clause 15. The display device any one of clauses 1 to 14, wherein the transistor comprises:
   a silicon transistor including a silicon semiconductor; and
   an oxide transistor disposed on the silicon transistor and including an oxide semiconductor,
   wherein:
      the first diode is disposed on the same layer as the silicon transistor; and
      the second diode is disposed on the same layer as the oxide transistor.
Clause 16. A display device comprising:
   a display panel including a display region and a non-display region,
   wherein the display panel comprises:
      a base layer overlapping the display region and the non-display region;
      a pad electrode exposed through a lower surface of the base layer;
      a pixel disposed on the upper surface of the base layer and comprising a light-emitting element overlapping the display region and a transistor electrically connected to the light-emitting element;
      a data line disposed on the upper surface of the base layer, overlapping the display region and the non-display region, and electrically connected to the transistor; and
      an electrostatic protection circuit electrically connected to the data line,
      wherein the electrostatic protection circuit comprises:
         a first diode disposed in the non-display region and including a silicon semiconductor; and
         a second diode disposed on the first diode and including an oxide semiconductor.
Clause 17. A method for manufacturing a display device including a display region and a non-display region, the method comprising:
   performing a test by applying a predetermined voltage through a re-test pad disposed in the non-display region; and
   removing a portion of the non-display region,
   wherein, in the performing of the test, an electrostatic protection circuit is electrically connected to the re-test pad,
   wherein the electrostatic protection circuit comprises:
      a first diode disposed in the non-display region; and
      a second diode disposed on the first diode and overlapping at least a portion of the first diode on a plane.
Clause 18. The method of clause 17, wherein, in the removing of a portion of the non-display region, a first portion in which the re-test pad is disposed is removed.
Clause 19. The method of clause 17 or clause 18, wherein, in the removing of a portion of the non-display region, a first portion in which the re-test pad is disposed and a second portion in which the electrostatic protection circuit is disposed are removed.
Clause 20. The method any one of clauses 17 to 19, further comprising forming a molding portion so as to cover at least a portion of the non-display region after the removing of a portion of the non-display region.

## Claims

1. A display device comprising:
a display panel including a display region and a non-display region, wherein the display panel comprises:
a base layer overlapping the display region and the non-display region and comprising an upper surface opposite a lower surface;
a pad electrode exposed through the lower surface of the base layer;
a pixel disposed on the upper surface of the base layer and comprising a light-emitting element overlapping the display region and a transistor electrically connected to the light-emitting element;
a data line disposed on the upper surface of the base layer, overlapping the display region and the non-display region, and electrically connected to the transistor;
an electrostatic protection circuit electrically connected to the data line; and
a connection electrode electrically connecting the data line and the pad electrode to each other in the non-display region, and
the electrostatic protection circuit comprises:
a first diode disposed in the non-display region; and
a second diode disposed on the first diode and overlapping at least a portion of the first diode in a plan view.

2. The display device of claim 1, wherein
the first diode comprises a silicon semiconductor, and
the second diode comprises an oxide semiconductor.

3. The display device of claim 1 or claim 2, wherein the second diode entirely overlaps the first diode.

4. The display device of any one of claims 1 to 3, wherein
the data line extends in a first direction, and
a length of the electrostatic protection circuit in the first direction is in a range of about 200 micrometers to about 300 micrometers.

5. The display device of any one of claims 1 to 4, wherein
the display panel further comprises a plurality of insulating layers disposed on the upper surface of the base layer,
the connection electrode is electrically connected to the pad electrode through a first contact hole,
the first contact hole passes through at least one of the plurality of insulating layers and is defined in the base layer, and
the connection electrode is electrically connected to the data line through a second contact hole passing through at least one of the plurality of insulating layers.

6. The display device of claim 5, wherein
the base layer comprises:
a first synthetic resin layer providing the lower surface of the base layer and having a first opening, the first opening exposes the pad electrode;
a first inorganic base layer disposed on the first synthetic resin layer and having a second opening, the second opening exposes the pad electrode and corresponds to the first opening;
a second inorganic base layer disposed on the first inorganic base layer and covering the pad electrode; and
a second synthetic resin layer disposed on the second inorganic base layer, and
the first contact hole passes through the second synthetic resin layer and the second inorganic base layer.

7. The display device of any one of claims 1 to 6, wherein the display panel further comprises an additional electrostatic protection circuit electrically connected to the data line and disposed closer to the display region than the electrostatic protection circuit.

8. The display device of any one of claims 5 to 7, wherein
the plurality of insulating layers comprise a first inorganic insulating layer,
at least a portion of the first diode is disposed below the first inorganic insulating layer, and
the second diode is disposed above the first inorganic insulating layer.

9. The display device of claim 8, wherein
the first diode comprises a first pattern disposed below the first inorganic insulating layer, the first pattern includes a silicon semiconductor, and
the second diode comprises a second pattern disposed above the first inorganic insulating layer, the second pattern includes an oxide semiconductor.

10. The display device of claim 9, wherein the first pattern and the second pattern overlap each other in a plan view.

11. The display device of any one of claims 1 to 10, wherein
the base layer comprises:
a first base portion overlapping the display region; and
a second base portion protruding from the first base portion in a first direction,
a width of the second base portion in a second direction intersecting the first direction is smaller than a width of the first base portion, and
the electrostatic protection circuit is disposed on the second base portion.

12. The display device of claim 11, wherein the display panel further comprises a lighting pad line disposed on the second base portion, extending to an end of the second base portion, and having a width greater than that of the data line.

13. The display device of any one of claims 1 to 12, wherein
the data line extends in a first direction, and
the electrostatic protection circuit comprises a plurality of electrostatic protection circuit portions spaced apart from each other in a second direction crossing the first direction.

14. The display device of any one of claims 1 to 13, wherein
the transistor comprises:
a silicon transistor including a silicon semiconductor; and
an oxide transistor disposed on the silicon transistor and including an oxide semiconductor,
the first diode and the silicon transistor are disposed on a same layer, and
the second diode and the oxide transistor are disposed on a same layer.

15. A method for manufacturing a display device including a display region and a non-display region, the method comprising:
performing a test by applying a voltage through a re-test pad disposed in the non-display region; and
removing a portion of the non-display region,
wherein in the performing of the test, an electrostatic protection circuit is electrically connected to the re-test pad,
wherein the electrostatic protection circuit comprises:
a first diode disposed in the non-display region; and
a second diode disposed on the first diode and overlapping at least a portion of the first diode in a plan view.
